# EUROPÄISCHE PATENTANMELDUNG

(11) **EP 2 937 445 A1**
(43) Veröffentlichungstag der Anmeldung: **28.10.2015**
(21) Anmeldenummer: 15164552.0
(22) Anmeldetag: 21.04.2015
(51) Int. Cl.: C23C 14/56, C23C 16/54

(54) **MODULARE VORRICHTUNG ZUM BEARBEITEN VON FLEXIBLEN SUBSTRATEN**

(30) Priorität: 23.04.2014 DE 102014105747
(71) Anmelder: Beier, Uwe, 01458 Ottendorf-Okrilla (DE)
(72) Erfinder: Beier, Uwe, 01458 Ottendorf-Okrilla (DE)
(74) Vertreter: Riechelmann & Carlsohn Patentanwälte

(57) **Zusammenfassung**

Die Erfindung betrifft eine Vorrichtung zum Bearbeiten flexibler, bandförmiger Substrate (18), wobei die Vorrichtung (1) einen Abwickler (13) und einen Aufwickler (15) für das flexible Substrat (18), Einrichtungen (25) zur Bearbeitung des flexiblen Substrates (18) sowie Mittel (23, 66, 75, 76, 81, 82, 91, 101, 111) zur Führung des flexiblen Substrates (18) vom Abwickler (13) zum Aufwickler (15) aufweist. Dabei ist vorgesehen, dass die Vorrichtung (1) einen modularen Aufbau mit mehreren aneinander angrenzenden Modulen (5, 6), durch die das flexible Substrat (18) geführt ist, besitzt, wobei die Module (5, 6) in einer Anordnung, die eine Basis (2) und daran anschließende, einander zugewandte Schenkel (3) aufweist, angeordnet sind.

## Beschreibung

Die Erfindung betrifft eine Vorrichtung zum Bearbeiten flexibler Substrate.

Flexible Substrate können aus den vielfältigsten Materialien bestehen, die bekanntesten sind Kunststoffe, Metalle, Papier und Textilien. Zunehmend sind auch Glasfaser-, Carbon-, Hybrid- und sogar Glasmaterialien in flexibler Form erhältlich. Die flexiblen Substrate werden üblicherweise in Form einer Rolle (die auch als Coil bezeichnet wird) transportiert und aufbewahrt. Für die Bearbeitung werden die flexiblen Substrate von einem ersten Coil, der auf einem Abwickler gelagert ist, abgewickelt, in der Prozess-Sektion bearbeitet und danach auf einem anderen, zweiten Coil, der auf einem Aufwickler gelagert ist, wieder aufgewickelt - daher auch der Name Rolle-zu-Rolle. Dies bedeutet, dass für eine Bearbeitungsmaschine für flexible Substrate jeweils zwei solcher Wickelstationen notwendig sind.

Bekannt sind Bearbeitungsanlagen für flexible Substrate in einem abgeschlossenen Raum, und zwar in unterschiedlichen Ausführungsformen und Gestaltungen. Bekannt sind dabei insbesondere diese zwei Hauptgruppen: Inline- und Batch-Anlagen. Bei einer Inline-Anlage werden die Substrate von außen (atmosphärenseitig) über ein Schleusensystem permanent in die Anlage geführt und nach der Bearbeitung über ein ebensolches wieder zurück an die Atmosphäre befördert. Solche Anlagen sind zumeist für robuste flexible Materialien geeignet. Für eine wirtschaftliche Lösung werden die Substrate dabei über Rollenschleusen, d. h. mit Kraft zusammengepresste Walzen, die oft gummiert sind, geführt, was eine nicht unerhebliche, starke Beanspruchung der Vorderseite des Substrates bewirkt.

Bei einer Batch-Anlage befinden sich hingegen beide Wickelstationen innerhalb des geschlossenen Raumes, welcher geöffnet werden kann bzw. muss, um die beiden Coils zu wechseln. Dabei wird der Öffnungszyklus maßgeblich durch die Länge des Substrats auf dem Coil sowie die notwendigen Arbeiten zum Wechseln bestimmt. Bisher bekannte Batch-Anlagen bestehen entweder: (i) aus einer Kammer (im Folgenden auch als Einkammer-Batch-Anlage bezeichnet) oder (ii) aus mehreren Kammern (im Folgenden auch als Mehrkammer-Batch-Anlage bezeichnet).

Einkammer-Batch-Anlagen erfordern ein möglichst umfangreiches Öffnen der Kammern, um die Coils wechseln zu können, da die Wickelsektionen nicht von der Prozess-Sektion abtrennbar sind. Dazu müssen jedoch die Bedingungen im Prozessbereich bei jedem Coilwechsel geändert werden, d. h. auf Atmosphärenbedingungen gebracht werden, was zeitaufwendig ist. Es ist darüber hinaus für die Prozesskomponenten und für sensible Prozesse nicht vorteilhaft, wenn zum Coilwechsel die gesamte Kammer geöffnet und damit auf Atmosphärenbedingungen gebracht werden muss. Weiterhin ist für die Zustandsänderung der gesamten Prozesskammer für jeden Coilwechsel ein hoher energetischer Aufwand notwendig, welcher sich in entsprechenden Betriebskosten der Anlage widerspiegelt. Bekannte Einkammer-Batch-Anlagen in Rohrform besitzen erhebliche Defizite hinsichtlich Zugänglichkeit und eignen sich maximal für Laboranlagen und kleinere Produktionsanlagen mit schmalen Substratbreiten.

Eine Einkammer-Batch-Anlage wird beispielsweise in DE 11 2008 001 359 T5 beschrieben.

Mehrkammer-Batch-Anlagen verfügen in der Regel über eine oder zwei zusätzliche Kammern, die häufig als Wickelkammern oder Load-Lock-Kammern bezeichnet werden und die entsprechend zwei bzw. ein Coil enthalten und über ein verschließbares Ventil mit der Prozesskammer verbunden sind. Der Vorteil dieser Lösung besteht darin, dass die Bedingungen in der mittleren Prozesskammer nicht verändert werden müssen, wenn die Coils gewechselt werden. Beispielsweise kann die Prozesskammer unter Prozessdruck bleiben, während die Load-Lock-Kammern auf Atmosphärendruck gebracht werden. Nachteile dieser Variante sind die zumeist sehr großen Stützabstände zwischen den Rollen, die zumeist nicht aktiv angetrieben sind. Das führt zu großen Belastungen des Substrates, weshalb solche Lösungen allgemein nur für stabile Substrate wie Metallbänder geeignet sind. Ihr Vorteil besteht in der Tatsache, dass die Prozesskammer von den Wickelsektionen mittels Ventilen abgetrennt werden kann.

Aus DE 693 32 355 T2 ist eine Vorrichtung zur Vakuumbeschichtung von Aluminiumbändern bekannt. Die Vorrichtung weist eine Abwickelkammer, in die ein Aluminiumcoil zur Beschichtung in der Vorrichtung eingebracht wird, einen Vakuumraum, der in mehrere Vakuumkammern unterteilt ist und in der die Beschichtung durchgeführt wird, und eine Aufwickelkammer auf, aus der ein Coil mit dem beschichteten Aluminiumband entnommen werden kann. Innerhalb des Vakuumraumes wird das Aluminiumband, abgesehen vom Eintritt in den Vakuumraum und dem Austritt aus dem Vakuumabraum ohne Richtungsänderung, d. h. in einer Ebene, geführt. Dazu sind Stützrollen in dem Vakuumraum vorgesehen. Über diese Stützrollen wird das unmittelbar zuvor beschichtete Aluminiumband geführt, wobei die Stützrollen die auf das Aluminiumband aufgebrachte Beschichtung berühren. Eine mechanische Einwirkung kann eine Beeinträchtigung der Beschichtung zur Folge haben. Überdies ist die Vorrichtung nur für die Beschichtung von Substratbändern geeignet, die über lange Strecken gezogen werden können. Die freien Längen, d. h. die Strecken, die ein Band ohne zusätzliche Unterstützung durch eine angetriebene Rolle zurücklegen muss, sind hoch. Um über lange Strecken gezogen werden zu können, müssen die Substratbänder eine hohe Stabilität aufweisen, um die auftretenden Zugkräfte ohne Beeinträchtigung zu überstehen. Diese Bedingung erfüllen nur stabile Substratbänder aus Metall. Substratbänder aus Kunststoff mit einer Stärke von 50 Mikrometern und weniger, beispielsweise nur 5 Mikrometern, können mit dieser Vorrichtung nicht bearbeitet werden.

Aus DE 10 2005 058 869 A1 ist eine weitere Vorrichtung zum Beschichten von Substratbändern bekannt. Auch diese Vorrichtung ist auf die Beschichtung von Substratbändern aus Metall ausgerichtet. Das Substratband wird über lange Strecken gezogen, die freien Längen sind hoch. Daher sind stabile Substratbänder erforderlich. Überdies weist die Vorrichtung noch sogenannte Verbindungskanäle auf, die die Wicklerkammern mit den Prozesskammern verbinden, was den Platzbedarf dieser Vorrichtung weiter erhöht.

In der Regel erfordert die Bearbeitung eines flexiblen Substrates mehrere Bearbeitungsschritte. Dabei können sich Anforderungen an die physikalischen und/oder chemischen Bedingungen des Gases, das für einen Bearbeitungsschritt im Innenraum einer Bearbeitungsstation - die auch als Prozessstation bezeichnet wird - erforderlich ist, von denen unterscheiden, die ein anderer Bearbeitungsschritt in einer anschließenden Bearbeitungsstation erfordert. Derartige physikalische und/oder chemische Bedingungen sind insbesondere der Druck, die Temperatur und die Zusammensetzung des Gases im Innenraum der Bearbeitungsstation. Es ist also erforderlich, die Innenräume der Bearbeitungsstationen voneinander zu trennen. Dazu können Strömungswiderstände vorgesehen sein, die einen Gasaustausch zwischen den Bearbeitungsstationen verhindern oder minimieren.

Für diesen Zweck werden nach dem Stand der Technik Rollschleusen eingesetzt, bei denen zwei Walzen mit Kraft aufeinander gepresst werden, um eine Dichtwirkung zu erzielen. Die Walzen sind dabei nicht angetrieben, und die Kraft ist erheblich, so dass die Lösung nur bei Metallbändern in Frage kommt. Außerdem werden dabei beide Flächenseiten des Substrates von den Walzen kontaktiert. Ferner sind sogenannte Spaltwiderstände bekannt, bei denen das Substrat im Freespan, also frei hängend zwischen zwei Stützstellen, in der Regel Rollen, durch einen Kanal geleitet wird. Der Kanal wird dabei meist in Form von Blechen ausgeführt. Aufgrund des Substratdurchhanges (dabei kann sich eine Kettenlinie in Abhängigkeit von der Bahnspannung bilden) sind nur Spalte im Bereich von mehreren Millimetern möglich, wenn eine Berührung des Substrates mit den feststehenden Kanalteilen verhindert werden soll. Das hat einen geringen Wirkungsgrad durch eine große Spaltweite zur Folge. Der Spalt muss relativ groß sein, damit das Substrat unter keinen Umständen in Kontakt mit der Gegenseite gerät. Das gilt insbesondere auch dann, wenn der Bahnzug aus prozesstechnischen Gründen einmal zu lose sein sollte, da durch die Relativgeschwindigkeit von Substrat und feststehender Schleuse eine enorme Beschädigung über einen langen Bereich eintreten würde, und zwar selbst bei einer kurzen Berührung der Gegenseite. Um dies mit Sicherheit auszuschließen, muss der Spalt deutlich größer, als eigentlich gewünscht, gewählt werden.

Es sind flexible Substrate bekannt, welche in Form eines Coils angeliefert werden und welche unter Beachtung von großen Umlenkradien über ein Wickelwerk transportiert werden müssen. Solche Substrate sind beispielsweise flexible Gläser. Während der Inbetriebnahme einer Vorrichtung, beim Chargenwechsel oder auch bei bestimmten Substratqualitäten bzw. -eigenschaften ist die Bruchgefahr besonders hoch. Ein Substratbruch bedeutet einen längeren Maschinenstillstand für eine umfangreiche Reinigung der Vorrichtung. Ein Substratbruch muss daher soweit wie möglich vermieden werden.

Aufgabe der Erfindung ist es, die Nachteile nach dem Stand der Technik zu beseitigen. Es soll insbesondere eine Vorrichtung zur Bearbeitung flexibler bandförmiger Substrate angegeben werden, die auch die Bearbeitung bruchempfindlicher Substrate, beispielsweise flexibler Gläser ermöglicht. Ferner soll sie leicht an unterschiedliche Aufgaben angepasst werden können. Außerdem soll es, wenn es die Art des Substrates oder die Art seiner Bearbeitung erfordern, möglich sein, das Substrat nur an seiner Rückseite, also der Flächenseite des Substrates, die keiner Bearbeitung unterzogen werden soll, zu kontaktieren. Überdies soll die Vorrichtung eine Bearbeitung des Substrates auch dann ermöglichen, wenn das Substrat in aufrechter Lage bearbeitet werden soll.

Diese Aufgabe wird durch die Merkmale der Ansprüche 1 und 15 gelöst. Zweckmäßige Ausgestaltungen der Erfindungen ergeben sich aus den Merkmalen der Unteransprüche.

Nach Maßgabe der Erfindung ist eine Vorrichtung zum Bearbeiten flexibler, bandförmiger Substrate vorgesehen, wobei die Vorrichtung einen Abwickler und einen Aufwickler für das flexible Substrat, Einrichtungen zur Bearbeitung des flexiblen Substrates sowie Mittel zur Führung des flexiblen Substrates vom Abwickler zum Aufwickler aufweist. Dabei besitzt die Vorrichtung einen modularen Aufbau mit mehreren aneinander angrenzenden Modulen, durch die das flexible Substrat geführt ist, besitzt, wobei die Module in einer Anordnung, die eine Basis und daran anschließende, einander zugewandter Schenkel aufweist, angeordnet sind.

Die erfindungsgemäß vorgesehene Anordnung der Module kann beispielsweise als C-förmige oder U-förmige Anordnung bezeichnet werden. Die Anordnung kann dabei beliebig zur Bodenebene ausgerichtet sein. Beispielsweise können sich beide Schenkel der Anordnung von der Basis nach oben erstrecken. Es kann aber auch eine liegende Anordnung vorgesehen sein, bei der beide Schenkel parallel zur Bodenebene verlaufen. Die Basis kann gerade oder gekrümmt sein. Ebenso können einer der Schenkel oder beide ganz oder teilweise gekrümmt sein. Sind die Basis und die Schenkel gekrümmt, so können die Module in den gekrümmten Bereichen auf einer Kreisbahn angeordnet sein. Allerdings müssen die einzelnen Module sich dabei nicht zwingend auf einer Kreisbahn befinden und auch nicht auf einen virtuellen Zentrumspunkt ausgerichtet sein: Die Module, die die Basis bilden, können auch in einer Linie, also gerade, angeordnet sein. Ebenso können die Module, die die Schenkel bilden, gerade angeordnet sein.

Die Schenkel stehen von der Basis an deren Enden winklig ab. Der Winkel zwischen den Schenkel kann 90°, aber auch mehr oder weniger betragen, vorzugsweise liegt er zwischen 45 und 135°. Vorzugsweise haben beide Schenkel dieselben Dimensionen und sind spiegelsymmetrisch zueinander ausgebildet, wobei die Symmetrieachse durch den geometrischen Mittelpunkt der Basis verläuft.

Die Gestaltung der Vorrichtung in Form eines C oder U ermöglicht einen modularen Aufbau der Vorrichtung aus vielen kleineren Modulen, welche sich leicht fertigen und der Reihenfolge und Anzahl nach entsprechend den Erfordernissen des Prozesses anordnen lassen. Dabei kann die Lage der Vorrichtung im Raum nach technischen Gegebenheiten und Erfordernissen frei gewählt werden kann. Besonders vorteilhaft ist eine Gestaltung, bei der die Basis der Bodenebene zugewandt ist, wie dies beispielsweise bei einem U oder einem um 90 Grad gedrehten C mit der Öffnung oben der Fall ist.

Der modulare Aufbau der erfindungsgemäßen Vorrichtung ermöglicht den Verzicht auf eine große Vakuumkammer. Er ermöglicht die Anordnung von mehreren Modulen hintereinander, in denen Prozesstechnik untergebracht ist. Die Prozesstechnik umfasst unter anderem Bearbeitungseinrichtungen, Führungsmittel und weitere Komponenten wie Ventile. Der modulare Aufbau gestattet es, die erfindungsgemäße Vorrichtung in Abhängigkeit von den Bearbeitungsprozessen zu konfigurieren, denen das flexible Substrat in der Vorrichtung unterzogen werden soll.

Abwickler und Aufwickler können jeweils ein gesondertes Modul oder ein gemeinsames Modul bilden. Diese Module werden im Folgenden als Wickelmodule bezeichnet. Die Wickelmodule können allein beide Schenkel der Anordnung bilden. Sie können aber auch an anderen Modulen angebracht sein, die Teil eines Schenkels sind.

Die erfindungsgemäße Vorrichtung ist für einen horizontalen Lauf der Substratbahn ebenso geeignet wie für einen vertikalen Lauf der Substratbahn. Zweckmäßigerweise läuft die Substratbahn horizontal oder vertikal.

Im Sinne der vorliegenden Erfindung ist ein horizontaler Lauf der Substratbahn ein Lauf, bei dem das flexible Substrat mit seinen Flächenseiten derartig geführt wird, dass seine Querachsen parallel zur Bodenebene oder mit einer Winkelabweichung von maximal +/-45° verlaufen. Diese Art der Führung des flexiblen Substrates wird im Folgenden als horizontale Führung bezeichnet. Im Sinne der vorliegenden Erfindung ist ein vertikaler Lauf der Substratbahn ein Lauf, bei dem das flexible Substrat mit seinen Flächenseiten derartig geführt wird, dass seine Querachsen senkrecht zur Bodenebene oder mit einer Winkelabweichung von maximal +/-89° verlaufen. Diese Art der Führung des flexiblen Substrates wird im Folgenden als vertikale Führung bezeichnet. Unter Querachse wird die Ausdehnung des flexiblen Substrates quer zu seiner Längsachse in der Flächenebene des flexiblen Substrates verstanden.

Eine vertikale Führung des flexiblen Substrates ist anspruchsvoller als eine horizontale Führung und kann daher eine Kompensation der auf das flexible Substrat einwirkenden Schwerkraft erfordern. Allerdings beansprucht die vertikale Führung das Substrat weniger, weshalb sie besonders gut für Substrate geeignet ist, welche empfindlich auf Biegung reagieren. Das sind insbesondere flexible Gläser. Zur Schwerkraftkompensation sind erfindungsgemäß besonders angepasste Führungsmittel vorgesehen.

Flexible Substrate, welche eine hinreichende Eigenstabilität aufweisen, können auch ohne Führungsmittel, die eine Schwerkraftkompensation bewirken, oder andere Hilfsmittel durch die Anlage transportiert werden. Flexible Substrate sind eigenstabil, wenn sie vertikal auf einer Körperkante stehen können, ohne einzuknicken. Dazu gehören einige flexible Gläser, dicke Kunststofffolien und spezielle Textilien. Bei solchen Substraten sind die Umschlingungswinkel in der Regel auch geringer als bei sensiblen, insbesondere zugempfindlichen Substraten. Eigenstabile Substrate können relativ einfach durch die erfindungsgemäße Vorrichtung transportiert werden, indem im - in Bezug auf die Bodenebene - unteren Bereich Stützrollen als Führungselemente vorgesehen werden, wie diese im Stand der Technik auch beim Transport von starren Elementen vorgesehen sind. Für eigenstabile Substrate ist es nicht zwingend notwendig, die Coils horizontal einzubringen - in diesem Fall können die Coils auch von der vertikalen Lage ab/aufgewickelt werden, wenn entsprechende Stützelemente, insbesondere Stützscheiben, als Führungsmittel an der Unterkante des flexiblen Substrates vorhanden sind. Eine Stützung des Coils beim Coil-Wechsel kann vorgesehen sein.

Eine Schwerkraftkompensation, insbesondere im Vakuum oder anderen von der Atmosphäre abweichenden Umgebungen, kann erreicht werden, wenn die Führungsmittel vorgesehen sind, die eine räumliche Verschränkung zum Bahnlauf bewirken. Das können insbesondere Rollen sein, wobei alle am Bahnlauf beteiligten Rollen oder nur ein Teil der Rollen verschränkte Rollen sein können. Alternativ oder zusätzlich können Rollen vorgesehen sein, die eine von der zylindrischen Geometrie abweichende Gestalt aufweisen. Vorzugsweise sind Führungsmittel zur Schwerkraftkompensation aus der Gruppe ausgewählt, die aus einem Paar benachbarter Rollen mit nichtparallelen Drehachsen, einer Bogenrolle und einer Rolle mit gewölbter Mantelfläche sowie Kombinationen davon besteht.

Die erfindungsgemäß vorgesehenen Führungsmittel zur Schwerkraftkompensation ermöglichen eine vertikale Führung selbst von instabilen flexiblen Substraten ohne seitliche Stützelemente. Stützelemente können zu Sicherheitszwecken sowie für die Inbetriebnahme der erfindungsgemäßen Vorrichtung dennoch vorgesehen sein.

Eine vertikale Führung des flexiblen Substrates bietet mehrere Vorteile bei dessen Bearbeitung: die Verschmutzungsneigung des flexiblen Substrates und der Prozessquellen durch die Bearbeitung ist geringer. Die Zugänglichkeit zur Prozesstechnik ist viel einfacher: die Prozesstüren und/oder -flansche mit der Prozesstechnik können auf Wagen montiert sein, welche sich auf Schienen bewegen und sich dadurch sehr einfach, meist von Hand, aber auch motorisch, öffnen lassen. Damit können einfache, in der Technik bekannte und bewährte Prinzipien eingesetzt und Sonderlösungen vermieden werden.

Vorzugsweise sind der Abwickler und der Aufwickler an den Innenseiten der Schenkel angeordnet. Der Abwickler und der Aufwickler können dabei in Wicklergehäusen angeordnet sein. Zweckmäßiger sind der Abwickler und der Aufwickler jeweils an dem Modul der Anordnung angeordnet, der das Ende des jeweiligen Schenkels bildet, solange der Abwickler und der Aufwickler nicht selbst das Ende des Schenkels bilden. In diesen Fällen sind der Abwickler am Anfang und der Aufwickler am Ende der Vorrichtung angeordnet, was vorteilhaft für die Zugänglichkeit sowohl der Wickler als auch der anderen Module für einen Kran, ein anderes Hebezeug oder einen Bediener ist. Das gilt insbesondere dann, wenn sich die Schenkel der Anordnung nach oben erstrecken.

In der vorliegenden Erfindung werden die Einrichtungen zur Bearbeitung des flexiblen Substrates auch als Bearbeitungseinrichtungen bezeichnet. Die Mittel zur Führung des flexiblen Substrates werden auch als Führungsmittel bezeichnet.

Die Flächenseite des flexiblen Substrates, die mittels einer oder mehreren Bearbeitungseinrichtungen bearbeitet werden soll, wird im Folgenden als Vorderseite, die andere Flächenseite des flexiblen Substrates hingegen als Rückseite bezeichnet.

Vorzugsweise weist ein Modul einen von einer Wandung umschlossenen Innenraum auf, wobei in der Wandung Durchführungen für das flexible Substrat ausgebildet sind. Die Durchführungen können abgedichtet sein. Dies ist jedoch nicht zwingend erforderlich, insbesondere dann nicht, wenn die Durchführung an ein Trennungsmodul angrenzt. Die Abschnitte der Wandung eines Moduls, an die kein anderes Modul angrenzt, bilden die Außenwände des Moduls. Die Auswände aller Module der erfindungsgemäßen Vorrichtung bilden gemeinsam das Gehäuse der Vorrichtung. Die Abschnitte der Wandung eines Moduls, die an ein anderes Modul grenzen, bilden die Innenwände des Moduls. In diesen Innenwänden sind zweckmäßigerweise die Durchführungen ausgebildet. Nicht jedes Modul muss Innenwände aufweisen. Das gilt insbesondere für das Trennungsmodul. Weist ein Modul keine Innenwände auf, so kann es mit den Stirnkanten seiner Außenwände an ein anderes Modul angrenzen, beispielsweise an eine Innenseite des anderen Moduls oder an die Stirnkanten der Außenwände dieses Moduls.

Im Innenraum eines Moduls können Bedingungen herrschen, die von den Umgebungsbedingungen abweichen. Insbesondere können sich Druck und/oder Temperatur im Innenraum von dem Druck bzw. der Temperatur in der Umgebung unterscheiden. Ebenso kann der Innenraum mit einem Gas anderer Zusammensetzung gefüllt sein. Es kann vorgesehen sein, dass in allen Modulen Bedingungen herrschen, die sich von denen der Umgebungen unterscheiden. Die Bedingungen können in den Modulen gleich oder verschieden sein. Es ist nicht zwingend erforderlich, in den Wicklergehäusen Bedingungen zu schaffen, die sich von denen der Umgebung unterscheiden. Aus diesem Grund ist ein einfacher Zugriff über die verschließbaren, beispielsweise mit Türen versehenen Öffnungen auf den Abwickler und/oder den Aufwickler möglich. Ein Coilwechsel erfordert somit keine Änderung der in den Modulen herrschenden Bedingungen, d. h. die Prozesssektion bleibt während eines solchen Wechsels unbeeinflusst.

Die erfindungsgemäße Vorrichtung kann weitere Komponenten, beispielsweise Ventile oder andere Mittel zur Abdichtung von Durchführungen umfassen. Sie kann ferner Gehäuse für die Auf- und Abwickler, die als Wicklergehäuse bezeichnet werden, umfassen. Vorzugsweise sind der Abwickler und der Aufwickler in separaten Wicklergehäusen angeordnet. Das ist vorteilhaft, wenn sich Abwickler und Aufwickler nicht an demselben Schenkel befinden. Sie können aber auch in einem gemeinsamen Wicklergehäuse untergebracht sein. Die Wicklergehäuse grenzen vorzugsweise jeweils an ein Modul der erfindungsgemäßen Vorrichtungen, besonders bevorzugt das jeweilige Modul, das das freiliegende Ende eines Schenkels bildet.

In einer Ausführungsform der Erfindung umfasst die Vorrichtung zumindest ein erstes Modul, in dem zumindest eine Bearbeitungseinrichtung angeordnet ist. Das erste Modul wird im Folgenden auch als Bearbeitungsmodul bezeichnet. Neben einer Bearbeitungseinrichtung können in dem ersten Modul auch Führungsmittel angeordnet sein. Die erfindungsgemäße Vorrichtung kann mehrere erste Module umfassen. Die Innenräume der ersten Module bilden die Kammern der erfindungsgemäßen Vorrichtung im Sinne eines Mehrkammersystems.

Vorzugsweise sind alle Bearbeitungsmodule in der Basis der erfindungsgemäßen Vorrichtung angeordnet. Durch die Anordnung der Bearbeitungsmodule in einer Reihe, wenn die Basis gerade ist, oder in einem Bogen, wenn die Basis gekrümmt ist, können nahezu beliebig viele Prozesssektionen vorgesehen sein.

Die erfindungsgemäße Vorrichtung kann ferner zumindest ein zweites Modul umfassen, das einen Strömungswiderstand zwischen Modulen, in deren Innenräumen unterschiedliche physikalische und/oder chemische Bedingungen herrschen, bildet. Das zweite Modul wird im Folgenden auch als Trennungsmodul bezeichnet. Zweckmäßigerweise ist ein Trennungsmodul zwischen zwei Bearbeitungsmodulen angeordnet. Das ist insbesondere dann vorteilhaft, wenn in den beiden Bearbeitungsmodulen, zwischen denen das Trennungsmodul angeordnet ist, unterschiedliche physikalische und/oder chemische Bedingungen herrschen. Im Innenraum des Trennmoduls sind zwei einander unter Ausbildung eines Spaltes gegenüberliegende und gegen die Wandung des Moduls abgedichtete Rollen angeordnet. Das flexible Substrat ist durch den Spalt geführt, wobei es mit einer seiner Flächenseite an einer der Rollen anliegt, während die andere Flächenseite freiliegt. Die Flächenseite des flexiblen Substrates, die an einer der Rollen anliegt, ist zweckmäßigerweise die Rückseite, während die Vorderseite des flexiblen Substrates mit keiner der Rollen in Kontakt kommt. Auf diese Weise wird sichergestellt, dass die Vorderseite nicht durch einen Kontakt mit der einer der Rollen des Trennmoduls beschädigt wird.

Es ist bevorzugt, dass der Spalt eine Spaltbreite besitzt, die nicht größer als das Zehnfache, stärker bevorzugt nicht größer als das Fünffache, noch stärker bevorzugt nicht größer als das Dreifache und besonders bevorzugt nicht größer als das Zweifache der Stärke des flexiblen Substrates ist. Die Spaltbreite ist dabei der Abstand zwischen den Mantelflächen der sich gegenüberliegenden Rollen des Trennmoduls. Die Spaltbreite ist im Vergleich zur Stärke des Substrates äußerst gering. Damit bilden die beiden Walzen einen Strömungswiderstand, wenn in benachbarten Räumen unterschiedliche physikalische und/oder chemische Bedingungen herrschen. Es sollte angemerkt werden, dass das Trennmodul kein Ventil ist. Ein Gasaustausch zwischen benachbarten Räumen wird nicht vollkommen unterbunden, aber erheblich minimiert. Im Gegensatz zum Stand der Technik besitzt die Trennung zweier Räume, hier der Bearbeitungsmodule, einen hohen Wirkungsgrad des Strömungswiderstandes. Im Gegensatz zum Stand der Technik ist dazu weder viel Platz, noch viel Material oder teure Pumptechnik notwendig, um das erforderliche Ergebnis zu erzielen. Das ist von erheblicher wirtschaftlicher Bedeutung.

Ist ein Trennungsmodul zwischen zwei Bearbeitungsmodulen angeordnet, so kann beispielsweise in dem ersten Bearbeitungsmodul eine Sauerstoffatmosphäre vorliegen, die für die Bearbeitung des flexiblen Substrates dort erforderlich ist. Im zweiten Bearbeitungsmodul, in das das flexible Substrat nach der Bearbeitung im ersten Bearbeitungsmodul gelangt und in dem es einer weiteren Bearbeitung unterzogen werden soll, ist Sauerstoff extrem schädlich und würde die Bearbeitung zunichte machen, selbst dann, wenn die Sauerstoffkonzentration auch nur in geringen Bereichen ansteigt. Das Trennungsmodul sorgt aufgrund seines Strömungswiderstandes für eine Gasseparation zwischen den beiden Bearbeitungsmodulen. Damit beschränkt das Trennungsmodul einen Gasaustausch zwischen den benachbarten Bearbeitungsmodulen erheblich.

Vorteilhafterweise sind beide Rollen gegenläufig angetriebene Rollen. Neben diesen beiden Rollen können in dem zweiten Modul auch Führungsmittel angeordnet sein. Die erfindungsgemäße Vorrichtung kann mehrere zweite Module umfassen.

Auch wenn das Trennungsmodul kein Ventil ist, so kann es dennoch die Funktionen eines Ventils haben, und das sowohl bei bewegtem Substrat als auch bei stillstehendem Substrat.

Im Gegensatz zum Stand der Technik, der als Strömungswiderstände fest montierte Kanäle als Spaltschleusen vorsieht, die einen Gasstrom von einer Bearbeitungsstation zur nächsten verhindern sollen, wird eine Beschädigung des flexiblen Substrates unter Einsatz des Trennungsmoduls als Strömungswiderstand verhindert. Nach dem Stand der Technik kann das flexible Substrat mit den Kanälen in Kontakt kommen, wodurch es deutlich beschädigt wird. Eine solche Beschädigung wird normalerweise nicht bemerkt, weil das beschädigte Band ebenso wie das unbeschädigte Band weiter bearbeitet und aufgewickelt wird. Die Beschädigung bleibt unerkannt und macht sich erst als Folgefehler bemerkbar, also bei gestiegenem Wert des Substrates oder des daraus hergestellten Produktes. Aus diesem Grunde werden nach dem Stand der Technik Spaltschleusen mit einem Sicherheitsabstand ausgelegt. Beispielsweise würde eine herkömmliche Spaltschleuse mit mindestens 15 mm Abstand, je nach Anlage mit bis zu 25 mm Abstand zwischen Kanaloberfläche und der Vorderseite des flexiblen Substrates ausgelegt werden. Mittels des erfindungsgemäßen Trennmoduls kann dieser Abstand bis auf wenige Zehntel-Millimeter oder sogar Hundertstel-Millimeter reduziert werden. Damit kann die Spaltbreite auf einen Wert von weniger als 1,00 mm, stärker bevorzugt weniger als 0,8 mm, noch stärker bevorzugt weniger als 0,5 mm eingestellt werden. Beispielsweise kann bei einem flexiblen Substrat von 0,1 mm Dicke der Spalt zwischen den beiden Rollen des Trennmoduls auf 0,2 bis 0,3 mm eingestellt werden. Damit verringert sich die Spaltbreite gegenüber dem Stand der Technik um das 100fache. Das hat einen wesentlichen wirtschaftlichen Effekt: Es sind wesentlich weniger Stufen und damit kleinere Kammern, hier Bearbeitungsmodule, erforderlich, was Material und Platz spart. Außerdem kann die Pumptechnik kleiner ausgelegt werden. Das ist mit erheblichen Kostenvorteilen verbunden, selbst wenn die beiden Rollen des Trennungsmoduls teurer als die Bleche der Spaltschleusen sein sollten.

Es können mehrere Trennungsmodule nacheinander angeordnet werden. Beispielsweise können zwei oder drei Trennungsmodule nacheinander angeordnet werden, um den Wirkungsgrad der Gastrennung weiter zu steigern.

Das Trennungsmodul als Trennvorrichtung kann auch unabhängig von der erfindungsgemäßen Vorrichtung als Strömungswiderstand zur Verhinderung des Gasaustausches zwischen Räumen eingesetzt werden. Beispielsweise kann die Trennvorrichtung als Mittel zur Abdichtung einer Durchführung zwischen zwei Bearbeitungsmodulen eingesetzt werden, wobei sie den Innenraum des einen Bearbeitungsmoduls von dem Innenraum des anderen Bearbeitungsmoduls trennt.

Die erfindungsgemäße Vorrichtung kann zumindest ein drittes Modul aufweisen, das als Übergangsmodul bezeichnet wird. Auch das Übergangsmodul kann verwendet werden, um Bearbeitungsmodule räumlich zu trennen. Es hat aber im Gegensatz zum Trennungsmodul kein Paar von Rollen, die als Strömungswiderstand dienen sollen. In dem dritten Modul können sich Führungsmittel befinden. Dabei kann es sich beispielsweise auch um Rollen für ein Trägermittel handeln. Ferner kann ein drittes Modul eine Rollenschleuse aufnehmen. Das kann nach Abschluss der Bearbeitung des flexiblen Substrates vorgesehen sein, beispielsweise nach dem oder zum Aufbringen einer Deckschicht oder eines Decklayers, der die Vorderseite des bearbeiteten flexiblen Substrates schützt.

Überdies kann die erfindungsgemäße Vorrichtung zumindest ein viertes Modul aufweisen, in dessen Innenraum nur Führungsmittel angeordnet sind. Ein viertes Modul kann in dieser Ausführungsform jeweils das freiliegende Ende der beiden Schenkel bilden. An das vierte Modul kann der Abwickler oder der Aufwickler angrenzen. Diese können aber auch an ein erstes oder zweites Modul angrenzen.

Es ist in vielen Fällen nicht erwünscht, dass die Vorderseite des flexiblen Substrates, die mittels einer oder mehreren Bearbeitungseinrichtungen bearbeitet werden soll, vor, während oder nach der Bearbeitung mit einem Element der erfindungsgemäßen Vorrichtung, insbesondere mit einem Führungsmittel in Kontakt kommt. In einer Ausführungsform ist daher vorgesehen, dass die Mittel zur Führung des flexiblen Substrates vom Abwickler zum Aufwickler so angeordnet sind, dass sie nur eine Flächenseite des flexiblen Substrates, nämliche dessen Rückseite, während seines Laufs vom Abwickler zum Aufwickler kontaktieren.

Die Führungsmittel können Führungsrollen, die geschwenkt werden können, und Hilfsrollen, die starr angeordnet sind, umfassen. Die Führungsmittel sollten so angeordnet sein, dass die freien Längen des flexiblen Substrates möglichst gering sind. Vorteilhafterweise ist zumindest ein Teil der Führungsmittel angetrieben. Damit wird die Zugbelastung des flexiblen Substrates vermindert.

In einer Ausführungsform der Erfindung ist zumindest eines der Führungsmittel ein Trägermittel mit einem bandförmigen Träger, der mit einer Flächenseite an dem flexiblen Substrat anliegt. Der bandförmige Träger wird im Folgenden auch als Trägerband bezeichnet. Das erfindungsgemäß vorgesehene Trägermittel ist insbesondere dann vorteilhaft, wenn das flexible Substrat, das in der Vorrichtung einer Bearbeitung unterzogen werden soll, ein bruchgefährdetes Substrat, beispielsweise ein flexibles Glas, ist. Das Trägermittel unterstützt den Transport des Substrates oder macht ihn überhaupt erst möglich. In einer Ausführungsform der Erfindung liegt der bandförmige Träger mit einer Flächenseite an einer Flächenseite des flexiblen Substrates, vorzugsweise seiner Rückseite, an. In einer anderen Ausführungsform der Erfindung liegt der bandförmige Träger mit einer Flächenseite an einer Längskante des flexiblen Substrates an.

Der bandförmige Träger sollte ein möglichst bruchsicheres und flexibles Trägersubstrat sein. Das Trägersubstrat kann beispielsweise ein Kunststoff oder Metall sein, wobei auch andere Werkstoffe in Betracht kommen, sofern sie bruchsicher und flexibel sind und ein Band bilden können. Der bandförmige Träger, vorzugsweise seine Flächenseite, die mit dem flexiblen Substrat in Kontakt gelangt, kann mit einer Beschichtung versehen sein, welche einerseits eine gute Haftung mit dem flexiblen Substrat, andererseits auch ein gutes Ablösen von diesem nach der Bearbeitung ermöglichen soll. Die Kombination dieser beiden Eigenschaften wird gelegentlich als Post-it-Effekt bezeichnet. Bei der Beschichtung kann es sich um eine Oberflächenmodifikation des Trägersubstrates handeln. Eine Oberflächenmodifikation kann durch verschiedene, bekannte Prozesse erhalten werden. Bei der Beschichtung kann es sich auch um Nano-Strukturen, eine oder mehrere Klebstoffschichten, Spacer oder Kombinationen davon handeln, wobei diese Aufzählung nicht abschließend ist. Es kann ebenso vorgesehen sein, dass die Verbindung mit dem flexiblen Substrat alternativ oder zusätzlich über mechanische Effekte, beispielsweise nach dem Prinzip des Klettverschlusses oder über formschlüssige Elemente wie Pin und Loch usw., hergestellt wird. Das Trägermittel kann mittels einer Heizungseinrichtung temperiert sein.

Der bandförmige Träger kann endlich oder endlos sein. Ist der bandförmige Träger endlich, so sind in der Vorrichtung ein Trägerband-Abwickler, von dem Trägerband abgewickelt, und ein Trägerband-Aufwickler, auf den das Trägerband aufgewickelt wird, vorgesehen. Trägerband-Abwickler und Trägerband-Aufwickler können jeweils ein Coil sein. Vorzugsweise ist der Trägerband-Abwickler in demselben Gehäuse wie der Abwickler für das flexible Substrat untergebracht. Ebenso ist es bevorzugt, dass der Trägerband-Aufwickler in demselben Gehäuse angeordnet ist, wie der Aufwickler für das flexible Substrat. Dabei können das flexible Substrat und der bandförmige Träger bereits im Gehäuse zusammengeführt werden, wodurch ein Kombinationssubstrat entsteht. Das Kombinationssubstrat läuft dann durch die Module der erfindungsgemäßen Vorrichtung bis zum Gehäuse, in dem sich der Aufwickler für das flexible Substrat und der Trägerband-Aufwickler befinden. Dort wird das Kombinationssubstrat wieder in das flexible Substrat und das Trägerband getrennt.

Ist der bandförmige Träger endlos, so ist er als Endlosband um voneinander beabstandete Rollen geführt, von denen vorzugsweise zumindest eine angetrieben ist. Ein Endlosband ist ein Band, dessen Stirnseiten aneinander befestigt sind. Es weist daher eine endlos umlaufende Bahn auf. Die endlose Bahn kann durch alle Module der erfindungsgemäßen Vorrichtung, nur ein Teil der Module oder gar nur durch ein einzelnes Modul verlaufen, wobei zumindest eines der Module ein Bearbeitungsmodul sein sollte. Liegt das Trägerband an dem flexiblen Substrat an, wird ebenfalls ein Kombinationssubstrat gebildet.

Das Trägerband kann die gleiche Breite aufweisen wie das flexible Substrat. Das ist jedoch nicht erforderlich. Es kann ebenso schmaler oder breiter sein. Das Trägerband kann im Kombinationssubstrat mittig, bezogen auf die Längsachsen des flexiblen Substrates und des Trägerbandes, angeordnet sein. Das ist jedoch nicht erforderlich. Insbesondere bei einer vertikalen Führung des flexiblen Substrates und damit des Kombinationssubstrates kann eine außermittige Anordnung des Trägerbandes, beispielsweise an der, in Bezug auf die Bodenebene, oberen Längskante des flexiblen Substrates vorteilhaft sein. Bei einer horizontalen Führung ist es hingegen vorteilhaft, wenn das Trägerband im Kombinationssubstrat mit seiner Flächenseite mittig zur Rückseite des flexiblen Substrates, bezogen auf die Längsachsen des flexiblen Substrates und des Trägerbandes, angeordnet ist.

Das Trägerband durchläuft als Kombinationssubstrat die Bearbeitungsmodule ebenso wie das flexible Substrat. Das Trägerband muss daher Eigenschaften aufweisen, die es die Bedingungen in den Bearbeitungsmodulen überstehen lassen. Dazu gehören Flexibilität, Dehnungsmöglichkeiten, Haftung, Lebensdauer, Temperaturbeständigkeit, Reinigungsmöglichkeiten, Verschleißbeständigkeit, je nach Anforderungen thermische bzw. elektrische Isolation oder Leitung, Verschmutzungsneigung. Der Fachmann wird das Material des Trägerbandes daher in Abhängigkeit von den konkreten Bedingungen der Bearbeitung des flexiblen Substrates wählen.

Ist das Trägermittel nur in einem Modul ausgebildet, so wird es als Segment-Trägermittel bezeichnet. Das Segment-Trägermittel weist vorzugsweise ein endloses Trägerband auf. Die Rollen für das endlose Trägerband sollten in dem Modul angeordnet sein. Das Trägerband kann an dem flexible Substrat mit einer Flächenseite anliegen, während die andere Flächenseite des flexiblen Substrates, wenn das Modul ein Bearbeitungsmodul ist, mittels der Bearbeitungseinrichtung bearbeitet wird. Vorzugsweise handelt es sich bei dem Segment-Trägerband um eine temperierbare Ausführung, so dass das flexible Substrat, solang es an dem Trägerband anliegt, temperiert, d. h. erwärmt oder gekühlt werden kann. Zweckmäßigerweise sind die Bearbeitungseinrichtungen in dem Bearbeitungsmodul derart angeordnet, dass das flexible Substrat einer Bearbeitung unterzogen werden kann, wenn es an dem Trägerband anliegt. Das Segment-Trägermittel vermindert die Zugbelastung des flexiblen Substrates. Es sorgt ebenfalls für geringe freie Längen. Zur weiteren Verringerung der Zugbelastung des flexiblen Substrates sollte das Segment-Trägermittel angetrieben sein.

Das Segment-Trägermittel bietet den Vorteil, dass während der Bearbeitung des flexiblen Substrates der sogenannte Freespan vermieden wird. Das Segment-Trägermittel kann das flexible Substrat, das an ihm anliegt, insbesondere während der Bearbeitung temperieren und gleichzeitig führen. Es können mehrere Module, insbesondere Bearbeitungsmodule vorgesehen sein, in denen sich ein Segment-Trägermittel befindet. Zusätzlich zu dem Segment-Trägermittel können in einem Modul auch Stützrollen vorgesehen sein, um den Freespan auch während der Bearbeitung des flexiblen Substrates möglichst kurz zu halten.

Das erfindungsgemäß vorgesehene Trägermittel ist insbesondere auch im Vakuum einsetzbar. Es ist von der Atmosphäre in der Umgebung unabhängig. Da Prozesse und Prinzipien, welche an Atmosphäre funktionieren und erprobt sind, aufgrund der vollkommen unterschiedlichen physikalischen Gegebenheiten in der Regel nicht ohne spezielle Anpassungen auf Umgebungen im Vakuum bzw. abweichend von der Atmosphäre übertragbar sind, stellt das Trägermodul eine besonders vorteilhafte Lösung für Rolle-zu-Rolle-Anwendungen dar.

Die erfindungsgemäße Vorrichtung bietet eine Vielzahl von Vorteilen. Unter anderem wird das flexible Substrat nur einseitig auf seiner Rückseite berührt. Die erfindungsgemäße Vorrichtung besitzt keine einzelne und damit große Kammer, sondern mehrere, kleinere Kammern, die von den Bearbeitungsmodulen gebildet werden. Kleine Kammern sind einfacher herzustellen und einfacher zu transportieren. Der modulare Aufbau ermöglicht eine beliebige Anzahl und Anordnung der Bearbeitungsmodule, so dass eine erfindungsgemäße Vorrichtung leicht verändert, insbesondere ergänzt werden kann. Überdies kann die erfindungsgemäße C- oder U-förmige Anordnung der Module große Biegeverhältnisse und insbesondere Gegenbiegungen vermeiden. Solche Biegeverhältnisse und Gegenbiegungen sind insbesondere dann nachteilig, wenn bruchgefährdete Substrate wie flexible Gläser bearbeitet werden. Solche Substrate sollten nicht über kleine Biegeradien gezogen und zudem so wenig wie möglich umgelenkt werden. Wenn möglich sollten sie nur in eine Richtung gebogen werden. Diese Richtung ist vorteilhafterweise die Richtung, die durch das Coil vorgegeben ist, von dem das flexible Substrat abgewickelt wird. Die Biegebelastung ist daher minimal. Die erfindungsgemäße Vorrichtung ermöglicht das hochproduktive Bearbeiten von flexiblen Substraten in einem abgeschlossenen Raum mit von der Umgebung unterschiedlicher Atmosphäre.

Die erfindungsgemäße Vorrichtung erlaubt die Bearbeitung von flexiblen Substraten, die - im Vergleich zum Stand der Technik - eine geringe Stabilität aufweisen, weil Zugbelastungen minimiert werden und eine Unterstützung durch erfindungsgemäße Trägermittel möglich ist. So ist die Vorrichtung beispielsweise nicht nur für die Bearbeitung von flexiblen Substraten aus Metall, sondern auch aus Kunststoff und insbesondere für flexibles Glas geeignet. Die Vorrichtung ist insbesondere auch zur Bearbeitung von flexiblen Substraten mit Dicken von 5 bis 50 Mikrometern geeignet. Das gilt auch, wenn die flexiblen Substrate aus Kunststoff bestehen.

Der Ausdruck "Wicklergehäuse" bezeichnet dabei ein Gehäuse, in dem sich der Abwickler, der Aufwickler oder beide befinden. Zusätzlich können sich in dem Gehäuse weitere Wickler befinden, beispielsweise für ein Trägerband, eine Zwischenlage, die auch als Interleaf bezeichnet wird, oder beides. Es ist nicht erforderlich, separate Kammern oder Gestelle für den Abwickler oder den Aufwickler vorzusehen, die den Aufwickler, den Abwickler oder beide unabhängig von den Modulen der Vorrichtung halten. Ausreichend ist es vielmehr, wenn der Abwickler, der Aufwickler oder, was bevorzugt ist, beide direkt an einem oder mehreren Modulen der erfindungsgemäßen Vorrichtung befestigt sind.

Eine Zwischenlage ist ein bandförmiges Substrat, das zur Trennung benachbarter Wicklungen des flexiblen Substrates auf einem Coil eingesetzt wird. Ist eine Zwischenlage auf einem Coil vorhanden, von dem das flexible Substrat abgewickelt werden soll, so muss die Zwischenlage aufgewickelt werden, wenn das flexible Substrat vom Coil abgewickelt wird. Dazu ist zweckmäßigerweise ein Aufwickler für die Zwischenlage in dem Wicklergehäuse vorgesehen, in dem sich der Abwickler für das flexible Substrat befindet. Soll eine Zwischenlage zwischen die Wicklungen des in der Vorrichtung bearbeiteten flexiblen Substrats gelegt werden, so muss die Zwischenlage abgewickelt werden, wenn das flexible Substrat auf das Coil aufgewickelt wird. Dazu ist zweckmäßigerweise ein Abwickler für die Zwischenlage in dem Wicklergehäuse vorgesehen, in dem sich der Aufwickler für das flexible Substrat befindet.

Innerhalb der Wicklergehäuse können Mittel zur Änderung der Ausrichtung der Substratbahn von einer ersten Ebene in eine zweite, orthogonale Ebene vorgesehen sein. Diese Umlenkung wird im Folgenden auch als "90°-Umlenkung" bezeichnet. Geeignete Mittel sind beispielsweise Umlenkrollen oder -walzen. Eine solche Umlenkung ist insbesondere dann zweckmäßig, wenn der vertikale Bahnlauf in der ProzessSektion an den beiden Enden für den Abwickler und den Aufwickler in einen horizontalen Bahnlauf umgelenkt werden soll. Damit kann einerseits erreicht werden, dass sich an den Coils die aus der Standard-Lösung bekannten Gegebenheiten einstellen, zum anderen können die Coils dann einfach und wie gewohnt mit einem Hebezeug, beispielsweise einem Kran gewechselt werden. Zusätzlich kann erreicht werden, dass die Prozesstechnik an separaten Türen an den Modulen angebracht werden kann, welche sich dann auf einfache Weise öffnen lassen. Beispielsweise können die Türen auf einem Wagen befestigt sein, welcher auf Schienen läuft, es kann aber beispielsweise auch ein Gabelstapler genutzt werden. Insgesamt bietet diese Ausführungsform eine gute Zugänglichkeit zu den Modulen, was eine einfache Bedienung und einen einfacheren Service erlaubt.

Alternativ oder zusätzlich zur Umlenkung der Substratbahn in den Wicklergehäusen kann eine Umlenkung auch in den Modulen der Prozesssektion erfolgen, was beispielsweise nach einer Vorbehandlung zweckmäßig ist. Damit können die Coils horizontal transportiert und ab- bzw. aufgewickelt werden, die Substratbahn aber dennoch in vertikaler Führung durch die Prozesssektion oder Abschnitte davon transportiert werden.

Im Gegensatz zum Stand der Technik weisen die Wicklergehäuse vorzugsweise keine Zwischenkammern oder separaten Vakuumkammern auf, die von den Coils abtrennbar sind und in denen Temperatur- und/oder Druckverhältnisse geschaffen werden können, die sich von dem Raum unterscheiden, in dem sich das Coil befindet. Zweckmäßigerweise sind in dem oder den Wicklergehäusen verschließbare Öffnungen ausgebildet, die eine Ein- oder Ausbringung von Rollen des flexiblen Materials gestatten. Beispielsweise können Türen in den Wicklergehäusen vorgesehen sein. Zweckmäßigerweise sind die verschließbaren Öffnungen so ausgebildet, dass die Coils mittels eines Hebewerkzeuges aus den Wicklergehäusen entnommen oder in diese eingebracht werden können. In einer Ausfiihrungsform der Erfindung kann es ausreichend sein, wenn nur eine verschließbare Öffnung vorgesehen ist, wenn über diese Öffnung sowohl ein Coilwechsel am Abwickler als auch ein Coilwechsel am Aufwickler vorgenommen werden kann. Dies ist beispielsweise dann der Fall, wenn der Aufwickler und der Abwickler in einem gemeinsamen Wicklergehäuse angeordnet sind. Die Türen in den Wicklergehäusen können schwenkbar sein. Sie können sich beispielsweise nach oben, unten oder zur Seite öffnen lassen.

Die Wicklergehäuse sind von ihrem jeweils benachbarten Modul, in das das flexible Substrat aus dem Wicklergehäuse eintritt oder aus dem das flexible Substrat in das Wicklergehäuse austritt, absperrbar. In beiden Fallen wird das flexible Substrat durch eine abgedichtete Durchführung, beispielsweise ein Ventil, geführt, das in dem Modul ausgebildet ist. Die Ventile werden in der Regel nur gesperrt, wenn kein Substratlauf erfolgt, d. h., die Vorrichtung befindet sich im Stillstand. Nach einem Coilwechsel können dann die Türen in den Wicklergehäusen geschlossen und in den Wicklergehäusen die gleichen Bedingungen wie im Hauptbereich hergestellt werden. Schließlich können die Ventile wieder geöffnet und der Substratlauf zur Bearbeitung des Substrates in der Kammer wieder gestartet werden.

Die Bearbeitungsmodule haben vorzugsweise die gleichen Dimensionen. Ebenso haben die Trennungsmodule vorzugsweise die gleichen Dimensionen, die sich allerdings von denen der Bearbeitungsmodule unterscheiden können. Gleiches gilt für die dritten und vierten Module. Im Ergebnis sind die Investitionskosten, die mit der erfindungsgemäßen Vorrichtung verbunden sind, aufgrund der vielen Wiederholteile/Gleichteile, da zumindest die Bearbeitungsmodule geometrisch gleich ausgelegt werden können, gering. Eine einfache, schnelle und sichere Inbetriebnahme ist möglich. Auch die Betriebskosten sind vergleichsweise günstig.

Die Module, mit Ausnahme der Wickelmodule, bilden die Prozesssektion der erfindungsgemäßen Vorrichtung. Die Wickler und die Wicklergehäuse bilden die Wickelsektionen. Vorzugsweise sind alle technologischen Einheiten - also alle Module mit Ausnahme der Wickelmodule - zwischen den Wickelsektionen angeordnet. Diese liegen außen und sind zur Prozesssektion durch Ventile absperrbar.

Die erfindungsgemäß vorgesehene Anordnung der Wickelsektionen verhindert eine Überschneidung mit der Wickelsektionen mit der Prozesssektion. Daher sind die Bedien- und Wartungsbereiche durch die C- oder U-Form gut voneinander separiert. Durch die möglichst optimale Anpassung der Prozesssektion an den abzubildenden Prozess kann die Geometrie der Prozesssektion erheblich variieren. Die Prozesssektion kann beispielsweise eine runde, eckige, gestufte oder schräge Gestalt oder Kombinationen davon haben. Auch die geometrische Gestaltung der zumindest einen, meist jedoch zwei Wickelsektionen kann nach Randbedingungen wie Coilabmessungen, Kranhöhe, Bühnenhöhe usw. unterschiedlichste Ausführungsformen aufweisen, beispielsweise eine horizontale, vertikale oder schräge Tür.

Insgesamt bietet die erfindungsgemäße Vorrichtung einen guten Zugang zu allen Modulen und den Wicklern. Aufgrund der geringen Größe der Wicklergehäuse im Vergleich zur übrigen Vorrichtung besteht eine uneingeschränkte Zugänglichkeit zu den Modulen, insbesondere den Bearbeitungsmodulen. Die Zugänglichkeit der Module bleibt während eines Coilwechsels unbeeinflusst.

Die erfindungsgemäße Vorrichtung wird zweckmäßigerweise als Batch-Anlage betrieben. Sie kann als Inline-Anlage betrieben werden, wenn das flexible Substrat und die erforderliche Art der Bearbeitung das erlauben.

Die erfindungsgemäße Vorrichtung ermöglicht die Bearbeitung von Substraten, die nach dem Stand der Technik nicht in Mehrkammersystemen bearbeitet werden konnten.

Nach Maßgabe der Erfindung ist ferner eine Vorrichtung zur Trennung von zwei Räumen vorgesehen, in denen unterschiedliche physikalische und/oder chemische Bedingungen herrschen, wobei die Vorrichtung eine Kammer mit einer Durchführung zum Einbringen eines flächigen Substrates in die Kammer und einer Durchführung zum Ausbringen des Substrates aus der Kammer aufweist und wobei in der Kammer zwei einander unter Ausbildung eines Spaltes gegenüberliegende und gegen die Wandung der Kammer abgedichtete Rollen angeordnet sind. Durch den Spalt kann das Substrat geführt derart geführt werden, dass es mit einer seiner Flächenseiten an einer Rolle anliegt, während die andere Flächenseite freiliegt. Der Spalt besitzt vorzugsweise eine Spaltbreite, die nicht größer als das Zehnfache der Stärke des flächigen Substrates ist. Weitere Merkmale dieser Vorrichtung ergeben sich aus der Beschreibung des Trennungsmoduls. Die Vorrichtung ist nicht nur für flexible Substrate geeignet, sondern auch für Platten, beispielsweise Glasplatten. Sie kann in Inline-Anlagen eingesetzt werden.

Die Erfindung wird nachstehend anhand von Ausführungsbeispielen, die die Erfindung nicht einschränken sollen, unter Bezugnahme auf die Zeichnungen näher erläutert. Dabei zeigen
- Fig. 1: eine schematische Querschnittsdarstellung einer ersten Ausführungsform, der erfindungsgemäßen Vorrichtung mit gerader Basis;
- Fig. 2: eine schematische Querschnittsdarstellung einer zweiten Ausführungsform der erfindungsgemäßen Vorrichtung mit gekrümmter Basis;
- Fig. 3: eine weitere schematische Querschnittsdarstellung der zweiten Ausführungsform der erfindungsgemäßen Vorrichtung mit vergrößert dargestelltem Abwickler und Aufwickler;
- Fig. 4: eine Teildarstellung der zweiten Ausführungsform der erfindungsgemäßen Vorrichtung, in der ein Wicklergehäuse gezeigt ist;
- Fig. 5: eine schematische Darstellung eines in den Figuren 3 und 4 gezeigten Wicklergehäuses von vorn;
- Fig. 6: eine schematische Darstellung des in Fig. 5 gezeigten Wicklergehäuses von der Seite;
- Fig. 7: eine Teildarstellung einer dritten Ausführungsform der erfindungsgemäßen Vorrichtung, in der im Wicklergehäuse zwei Coils für flexible Substrate angeordnet sind;
- Fig. 8: eine Detaildarstellung einer vierten Ausführungsform der erfindungsgemäßen Vorrichtung, in der im Wicklergehäuse ein Coil für ein flexibles Substrat angeordnet ist, wobei das flexible Substrat gegenläufig abgewickelt wird;
- Fig. 9: eine schematische Darstellung einer fünften Ausführungsform, der erfindungsgemäßen Vorrichtung, in der ein Trägermittel mit endlosem bandförmigen Träger vorgesehen ist;

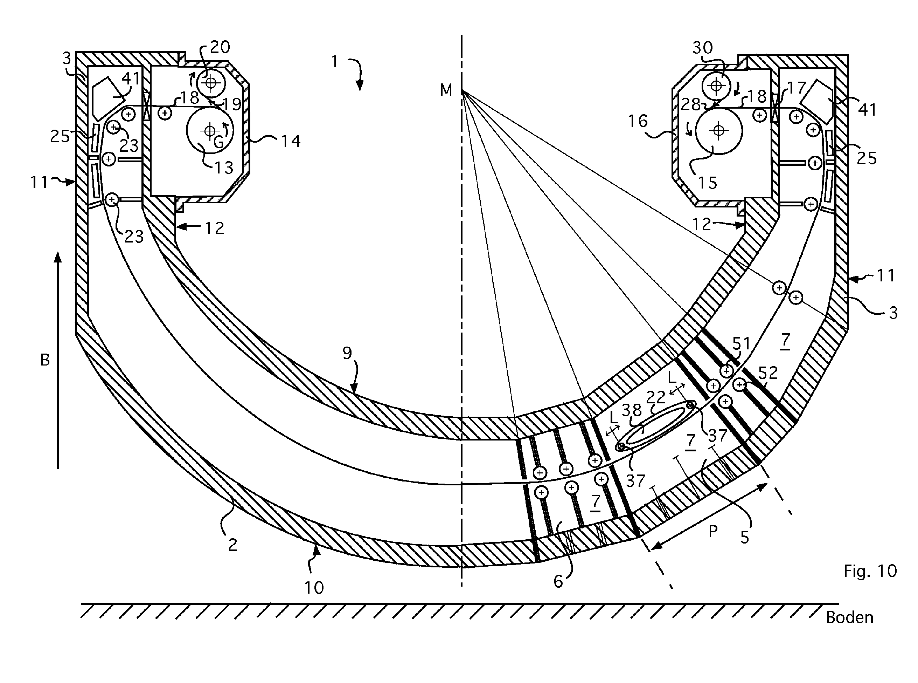

- Fig. 10: eine schematische Darstellung einer sechsten Ausführungsform, der erfindungsgemäßen Vorrichtung, in der ein Segment-Trägermittel vorgesehen ist;
- Fig. 11: eine schematische Prinzipdarstellung einer ersten Ausführungsform eines erfindungsgemäßen Trennungsmoduls;
- Fig. 12: eine schematische Darstellung einer zweiten Ausführungsform eines erfindungsgemäßen Trennungsmoduls;
- Fig. 13: eine schematische Darstellung einer siebten Ausführungsform der erfindungsgemäßen Vorrichtung mit vertikaler Führung des flexiblen Substrates;
- Fig. 14: eine schematische Darstellung einer achten Ausführungsform, der erfindungsgemäßen Vorrichtung mit vertikaler Führung des flexiblen Substrates und einem Trägermittel mit endlichem bandförmigen Träger;
- Fig. 14a: eine Detaildarstellung der achten Ausführungsform, der erfindungsgemäßen Vorrichtung, in der das in vertikaler Führung laufende flexible Substrat mit einer unten liegenden, horizontalen Stützrolle und einer hinten liegenden, vertikalen Führungsrolle gezeigt ist;
- Fig. 15: eine schematische Darstellung einer ersten Ausführungsform, eines Führungsmittels zur Schwerkraftkompensation (Fig. 15a: Ansicht von vor; Fig. 15b: Schnittdarstellung entlang Linie A--A);
- Fig. 16: eine schematische Darstellung einer zweiten Ausführungsform eines Führungsmittels zur Schwerkraftkompensation (Fig. 16a: Ansicht von vorn; Fig. 16b: Schnittdarstellung entlang Linie A--A);
- Fig. 17: eine schematische Darstellung einer dritten Ausführungsform, eines Führungsmittels zur Schwerkraftkompensation;
- Fig. 18: eine schematische Darstellung einer vierten Ausführungsform eines Führungsmittels zur Schwerkraftkompensation und
- Fig. 19: eine schematische Darstellung einer dritten Ausführungsform eines erfindungsgemäßen Trennungsmoduls.

In den Figuren haben gleiche Bezugszeichen dieselbe Bedeutung, sofern nichts anderes angegeben ist.

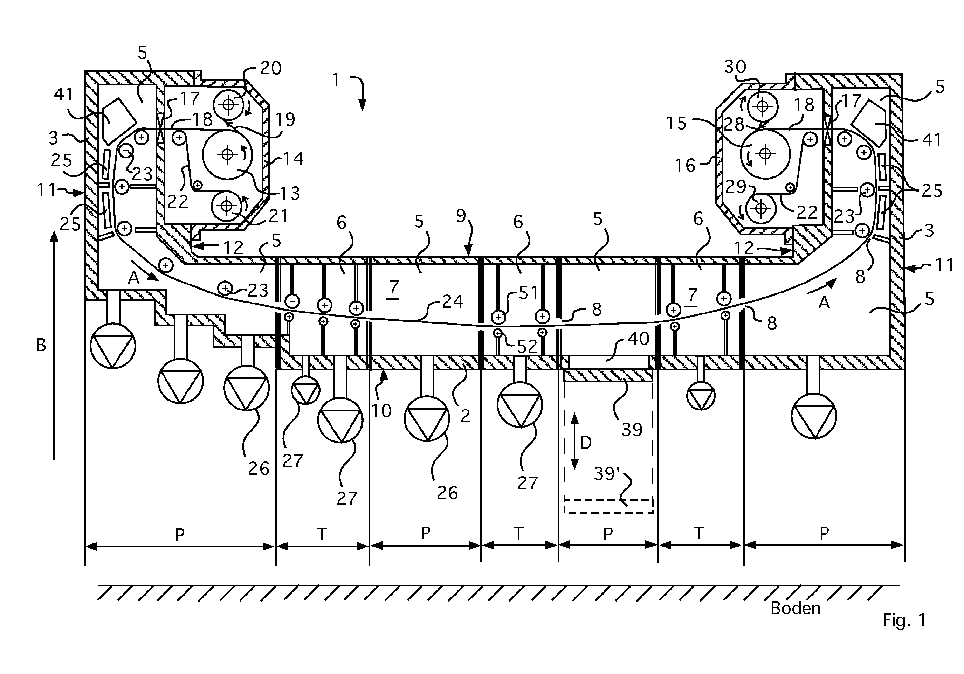

Die in Fig. 1 gezeigte erste Ausführungsform einer erfindungsgemäßen Vorrichtung 1 weist einen C-förmigen Querschnitt auf. Dabei ist die Basis 2 der Vorrichtung 1 dem Boden zugewandt. Die Schenkel 3 der Vorrichtung 1 erstrecken sich senkrecht von der Basis 2 nach oben, im Wesentlichen parallel zur Bezugsrichtung (Pfeil B), die senkrecht zur Bodenebene verläuft. Die Basis 2 und die Schenkel 3 sind aus mehreren Modulen 5, 6 zusammengesetzt. Die Module 5 sind Bearbeitungsmodule, die Module 6 Trennungsmodule.

Die Module 5, 6 weisen jeweils einen von einer Wandung umgebenen Innenraum 7 auf. Die Module 5, 6 grenzen an ihren Stirnseiten aneinander. In den Stirnseiten der Module 5, 6 sind Durchführungen 8 für das flexible Substrat 18 ausgebildet. Die Abschnitte der Wandung der Module 5, 6, an die kein anderes Modul angrenzt, bilden die Außenwände 9, 10, 11, 12 der Vorrichtung 1. Die Module 5, 6 der Basis 2 bilden dabei die Unterseite 9, die der Bodenebene zugewandt ist, und die Oberseite 10, die der Bodenebene abgewandt ist, der Vorrichtung 1 aus. Die Module 5, die sich an den Enden der Basis 2 befinden, und die Module 5, die die Schenkel 3 bilden, bilden dabei die äußeren Seitenwände 11 und die inneren Seitenwände 12 der Vorrichtung 1. Es ist in Fig. 1 zu erkennen, dass die Basis 2 eine ebene Oberseite 9, aber eine an einem Ende gestufte Unterseite 10 aufweist, weil eines der Module 5 einen gestuften Wandungsabschnitt besitzt.

An den inneren Seitenwänden 12 der Vorrichtung 1, d. h. den Innenseiten der Schenkel 3, sind der Abwickler 13 in einem Wicklergehäuse 14 und der Aufwickler 15 in einem Wicklergehäuse 16 angeordnet. Dabei grenzen die Wicklergehäuse 14, 16 jeweils an ein Modul 5 der Vorrichtung 1 an. Die Durchführung 8 zwischen diesen Modulen 5 und den Wicklergehäusen 14, 16 ist als Ventil 17 ausgestaltet.

Von dem Abwickler 13 wird das flexible Substrat 18 abgewickelt. Dabei wird die Zwischenlage 19, die die Wicklungen des flexiblen Substrates 18 auf dem Coil trennt, von dem Coil abgewickelt und auf einem gesonderten Aufwickler 20 für die Zwischenlage 19 aufgewickelt, der ebenfalls im Wicklergehäuse 14 angeordnet ist. Außerdem ist in dem Wicklergehäuse 14 ein Abwickler 21 für ein Trägermittel mit einem bandförmigen Träger 22 angeordnet. Der bandförmige Träger 22 ist ein endliches Trägersubstrat. Es wird im Wicklergehäuse 14 mit dem flexiblen Substrat 18 zusammengeführt, wodurch ein Kombinationssubtrat 24 gebildet wird. Das Kombinationssubstrat 24 besteht aus dem flexiblen Substrat 18 und bandförmigen Träger 22, der mit einer seiner Flächenseiten an der Rückseite des flexiblen Substrates 18 anliegt. Mittels des bandförmigen Trägers 22 wird das flexible Substrat 18 in horizontaler Führung durch die Module 5, 6 der Vorrichtung 1 transportiert. In den Wicklergehäusen 14, 16 und einigen Modulen 5 sind weitere Führungsmittel, insbesondere Führungsrollen 23 vorgesehen, um das Kombinationssubstrat 24 vom Abwickler 13 zum Aufwickler 15 zu transportieren. Es ist zu erkennen, dass die Führungsrollen 23 das flexible Substrat 18 nicht an seiner Vorderseite kontaktieren. Sie stehen nur in Kontakt mit dem Träger 22 des Kombinationssubstrates 24.

Ausgehend vom Abwickler 13 durchläuft das Kombinationssubstrat 24 zunächst ein Bearbeitungsmodul 5, das einen Schenkel 3 der Vorrichtung 1 bildet. In diesem Bearbeitungsmodul sind Prozessstationen 25 angeordnet, mit denen die Vorderseite des flexiblen Substrates bearbeitet wird. Anschließend durchläuft das Kombinationssubstrat 24 ein erstes Bearbeitungsmodul 5, das ein Ende der Basis 2 der Vorrichtung 1 bildet. In Fig. 1 sind einige Bearbeitungsmodule 5 der Basis 2 jeweils mit einer oder mehreren Pumpen 26 gezeigt, um zu verdeutlichen, dass sich die Bedingungen in dem Innenraum 7 der Bearbeitungsmodule 5, von denen in der Umgebung unterscheiden können. In den Bearbeitungsmodulen 5 der Basis 2 sind zur Vereinfachung der Darstellung keine Prozessstationen eingezeichnet, obwohl dort Prozessstationen zur Bearbeitung der Vorderseite des flexiblen Substrates 18 vorgesehen sind.

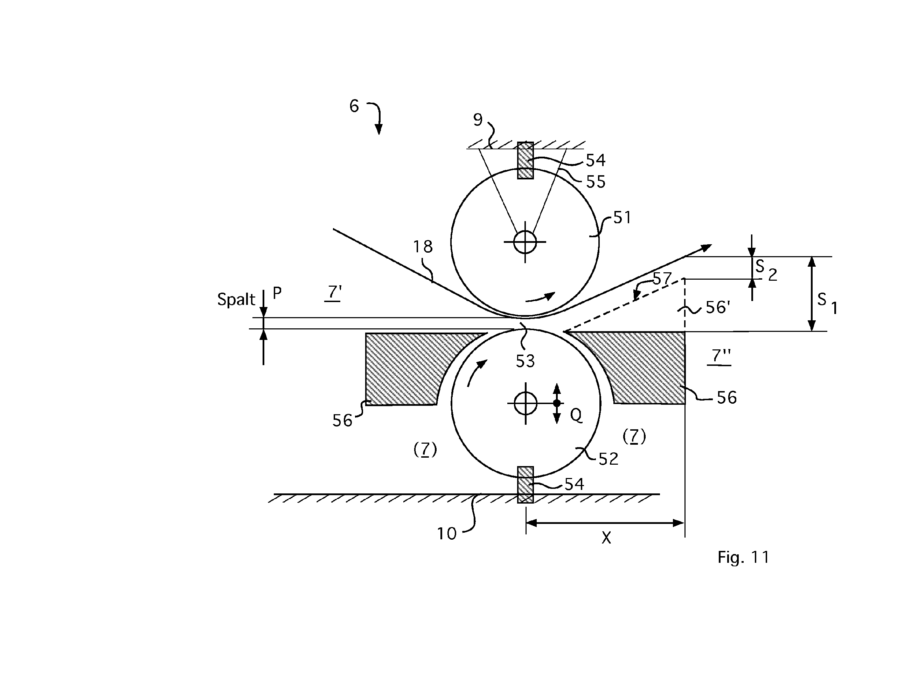

Nachdem das Kombinationssubstrat 24 das erste Bearbeitungsmodul 5 der Basis 2 durchlaufen hat, tritt es in ein erstes Trennungsmodul 6 ein. Der Aufbau und die Funktion der Trennungsmodule 6 werden im Zusammenhang mit den Figuren 11, 12 und 19, unten, beschrieben. Aus dem ersten Trennungsmodul 6 gelangt das Kombinationssubstrat 24 wiederum in Bearbeitungsmodul 5, dem sich ein zweites Trennungsmodul 6 und dann ein weiteres Bearbeitungsmodul 5 anschließen. Bei diesem Bearbeitungsmodul 5 ist beispielhaft ein Prozessflansch 39 gezeigt, um die leichte Zugänglichkeit zu den Prozessstationen in den Bearbeitungsmodulen 5 zu veranschaulichen. Der Prozessflansch 39 verschließt eine Öffnung 40 in der Wandung des Bearbeitungsmoduls 5. Der Prozessflansch 39 kann auf einem Wagen montiert und mittels Schienen bewegbar zwischen einer Position, in der er die Öffnung 40 verschließt, und einer Position 39', in der die Öffnung 40 geöffnet ist, sein (Pfeil D). Prozessflansche 39 und Öffnungen 40 können in jedem der Module 5, 6 ausgebildet sein.

Nach dem Passieren eines dritten Trennungsmoduls 6 gelangt das Kombinationssubstrat 24 in das Bearbeitungsmodul 5, das das andere Ende der Basis 2 der Vorrichtung 1 bildet, und von dort in das Bearbeitungsmodul 5, das den zweiten Schenkel 3 der Vorrichtung 1 bildet. An die innere Seitenwand 12 dieses Schenkels 3 grenzt der im Wicklergehäuse 16 angeordnete Aufwickler 20 an, auf dem das flexible Substrat 18 nach Trennung von dem bandförmigen Träger 22 unter Einschiebung einer Zwischenlage 28 aufgewickelt wird. Der bandförmige Träger 22 wird auf einem gesonderten Aufwickler 29, der in dem Wicklergehäuse 16 angeordnet ist, aufgewickelt. Die Zwischenlage 28 wird von einem Abwickler 30, der sich ebenfalls in dem Wicklergehäuse 16 befindet, abgewickelt.

Die Transportrichtung des Kombinationssubstrates 24 ist in Fig. 1 mit den Pfeilen A gekennzeichnet. Die Abschnitte in der Basis 2, in denen eine Bearbeitung des flexiblen Substrates 18 erfolgen kann, sind mit dem Buchstaben P, die Abschnitte in der Basis 2, die der Trennung der Bearbeitungsmodule 5 dienen, sind mit dem Buchstaben T gekennzeichnet. Es ist zu erkennen, dass jeweils ein Trennungsabschnitt T, der von einem Trennungsmodul 6 gebildet wird, zwischen zwei Prozessabschnitten P angeordnet ist. In Fig. 1 sind einige die Trennungsmodule 6 jeweils mit einer oder mehreren Pumpen 27 gezeigt, um zu verdeutlichen, dass sich die Bedingungen in dem Innenraum 7 der Trennungsmodule 6 von denen in der Umgebung unterscheiden können. In den Bearbeitungsmodulen 5, aber auch in den Trennmodulen 6 können Messinstrumente 41 angeordnet sein.

Die Anordnung der Module 5, 6 in Form eines nach oben offenen C bietet den weiteren Vorteil, dass die Bearbeitungsrichtung in den Bearbeitungsmodulen 6 von unten nach oben verläuft. Dies minimiert die Verschmutzung des flexiblen Substrates 18, was bei vielen Bearbeitungsverfahren vorteilhaft ist.

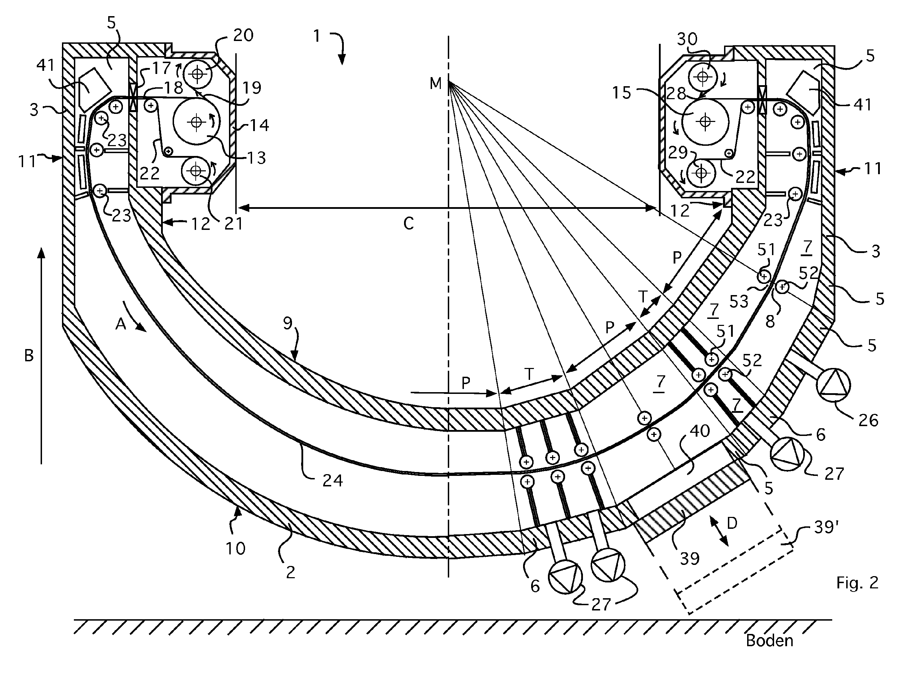

Die in Fig. 2 gezeigte zweite Ausfiihrungsform der erfindungsgemäßen Vorrichtung entspricht der in Fig. 1 gezeigten ersten Ausführungsform, außer dass die Basis nicht gerade, sondern gekrümmt ist. Demzufolge sind auch die Oberseite 10 und die Unterseite 9 der Basis 2 gekrümmt. Die Module 5, 6 der Basis 2 sind dabei auf einem Kreisbogen angeordnet, dessen Mittelpunkt M außerhalb der Basis 2 mittig zwischen dem Wicklergehäuse 14 und dem Wicklergehäuse 16 liegt. Zur Vereinfachung der Darstellung sind nicht alle Einzelheiten, die in Fig. 1 gezeigt werden, auch in Fig. 2 dargestellt. Insbesondere wurde auf die Darstellung aller Stirnseiten der Module 5, 6, die diese voneinander abgrenzen, verzichtet. Diese wurden nur in der rechten Hälfte der Darstellung widergeben. Der Abstand C zwischen den Wicklergehäusen 14 und 16 ermöglicht eine leichte Zugänglichkeit zu den Abwicklern 13, 21, 30 und den Aufwicklern 15, 20, 29.

Es ist in Fig. 2 weiterhin zu erkennen, dass die Durchführung 8 zwischen zwei benachbarten Bearbeitungsmodulen mittels einer Trennungsvorrichtung abgedichtet ist, die wie das Trennungsmodul 6 eine Hauptrolle 51 und eine Gegenrolle 52 aufweist, zwischen denen ein Spalt 53 ausgebildet ist. Auch hier liegt das Kombinationssubstrat 24 nur mit dem bandförmigen Träger 22, nicht aber mit der Vorderseite des flexiblen Substrates 18 an einer der Rollen 51, 52 an. Der bandförmige Träger 52 kontaktiert die Hauptrolle 51, während die Vorderseite des flexiblen Substrates 18 freiliegt. Weitere Einzelheiten zu diesem Prinzip der Trennung von Räumen, hier den beiden Innenräumen 7 der beiden Module 5, werden in den Figuren 11, 12 und 19 erläutert.

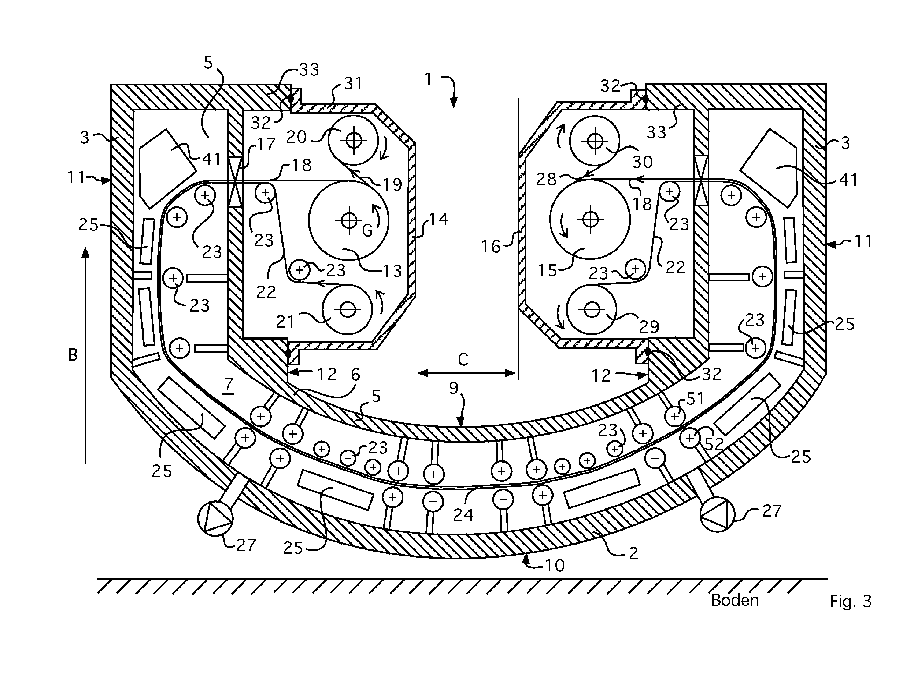

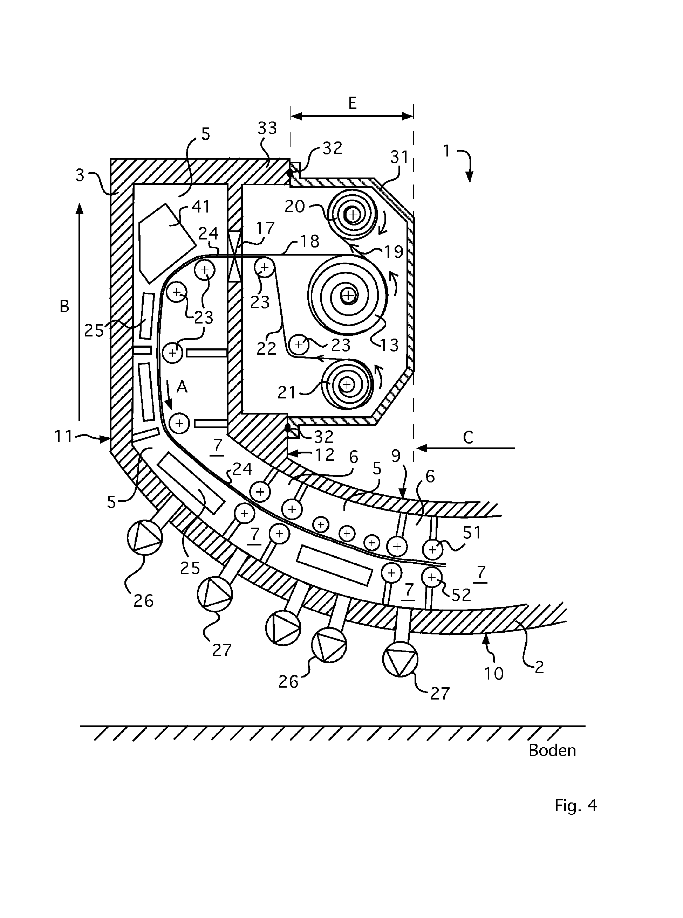

In Fig. 3 sind die Wicklergehäuse 14 und 16 vergrößert dargestellt, während die übrigen Bestandteile der Vorrichtung 1 nur schematisch und nicht vollständig gezeigt sind. Insbesondere wurde auf die Darstellung aller Stirnseiten der Module 5, 6, die diese voneinander abgrenzen, verzichtet. Die Wicklergehäuse 14 und 16 weisen Türen 31 auf, die an die starren Wandungen 33 der Wicklergehäuse 14, 16 angrenzen. Die Türen 31 sind dabei mittels umlaufender Dichtungen 32 an ihren Kanten, die an den starren Wandungen 33 der Wicklergehäuse 14, 16 anliegen, abgedichtet. Fig. 4 veranschaulicht die Entfernung der Zwischenlage 19 sowie die Bildung des Kombinationssubstrates 24 im Wicklergehäuse 14 weiter.

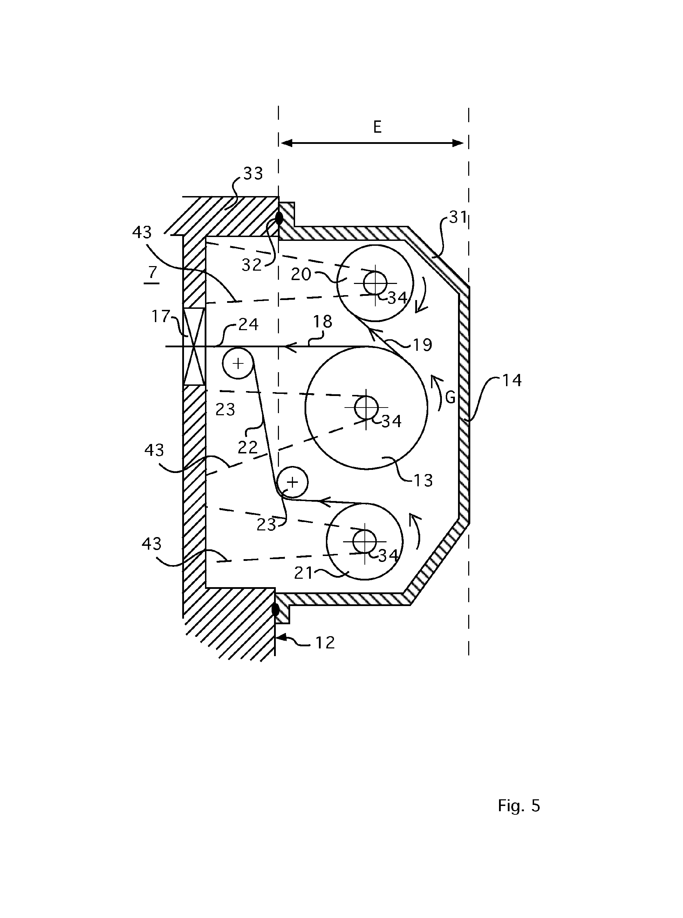

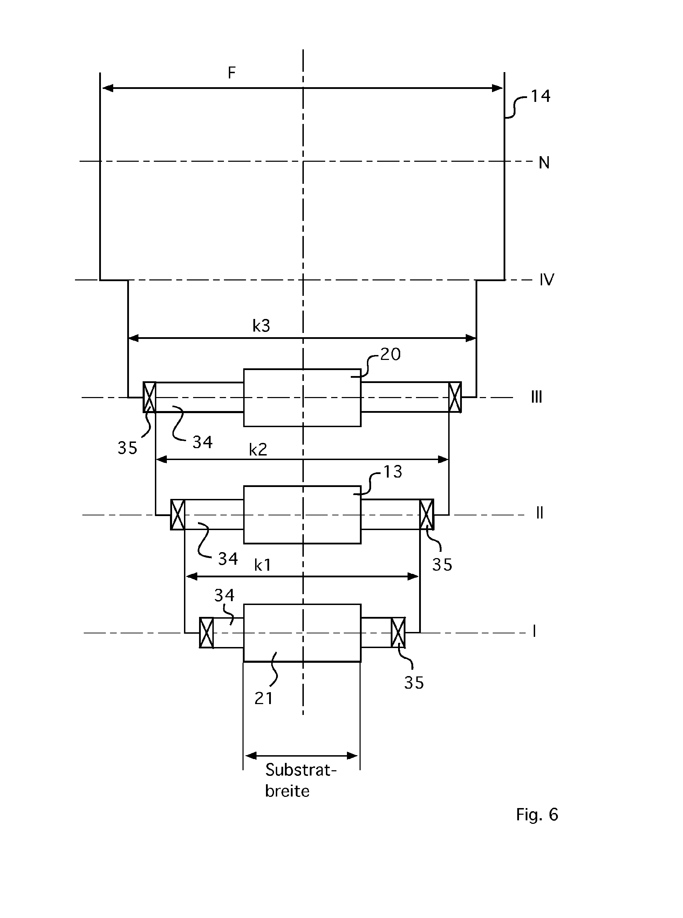

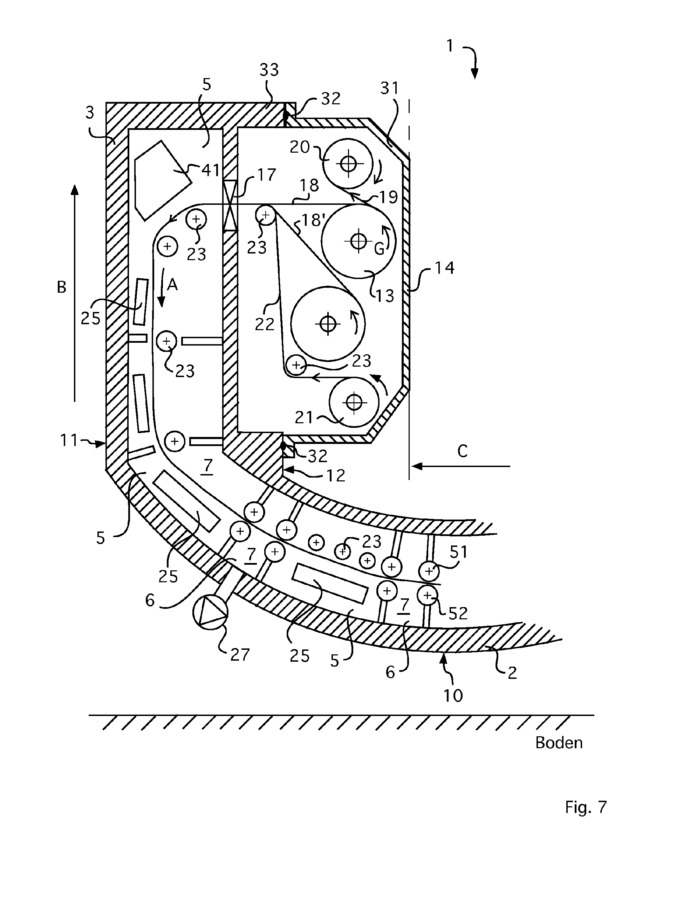

Die Figuren 5 und 6 veranschaulichen die gute Zugänglichkeit der Auf- und Abwickler am Beispiel des in den Figuren 3 und 5 gezeigten Wicklergehäuses 14. Nach dem Entfernen der Tür 31 des Wicklergehäuses 14 liegen der Abwickler 13 für das flexible Substrat, der Abwickler 21 für den bandförmigen Träger 22 sowie der Aufwickler 20 für die Zwischenlage 19 in einem horizontalen Bereich, der sich über die gesamte Ausdehnung der Wickler 13, 20, 21 erstreckt, frei. Dieser Bereich weist die Breite E und die Länge F auf. Das Wicklergehäuse 14 verengt sich von seiner Oberseite in Richtung seiner Unterseite stufenweise. Damit entstehen sogenannte Kranbereiche K, die in parallelen Ebenen zueinander verlaufen und von oben nach unten enger werden, sowohl in Breitenrichtung E als auch in Längenrichtung F. Die Trägerrollen 34 der Coils der Wickler 13, 20, 21 sind dabei in Lagern 35 gelagert, die in Höhe des Versatzes zwischen den Stufen ausgebildet sind. Es ist in Fig. 6 zu erkennen, dass mehrere Coils auf diese Weise übereinander in dem Wicklergehäuse 14 angeordnet werden. Alle Coils sind auf diese Weise von oben leicht zugänglich, beispielsweise mittels eines Krans, weil alle Kranbereiche K, die sich über einem Coil befinden, größer als der Kranbereich sind, in dem sich das Coil befindet, das entnommen werden soll. Die Anzahl der Kranbereich ist beliebig. Sie kann zwischen 2, vorzugsweise 3 und N liegen. In Fig. 6 sind die Ebenen, in den sich die Coils befinden, mit römischen Buchstaben gekennzeichnet. Ventil 17 (siehe Fig. 5) sollte geschlossen sein, wenn Coils in das Wicklergehäuse 14 eingesetzt oder daraus entnommen werden. Die Drehachsen der Coils müssen nicht in einer vertikalen Ebene liegen, sondern auch in Bezug auf einer vertikale Ebene versetzt zueinander sein (siehe auch Fig. 7). In Fig. 5 ist ferner zu erkennen, dass die Abwickler 13, 21 und der Aufwickler 20 mittels Gestellen 43 an der Wandung des Wicklergehäuses 14 befestigt sind.

Die dritte Ausführungsform der erfindungsgemäßen Vorrichtung entspricht der zweiten Ausführungsform, außer dass im Wicklergehäuse 14 zwei Abwickler 13, 13' für zwei flexible Substrate 18, 18' vorgesehen sind (Fig. 7). Noch im Wicklergehäuse 14 werden die beiden flexiblen Substrate 18, 18' und der bandförmige Träger 22 miteinander zu einem Kombinationssubstrat 24' vereinigt, wobei der bandförmige Träger 22 an der Rückseite des zweiten flexiblen Substrates 18' anliegt, während die Vorderseite des ersten flexiblen Substrates 18 freiliegt und in den folgenden Modulen 5 bearbeitet wird.

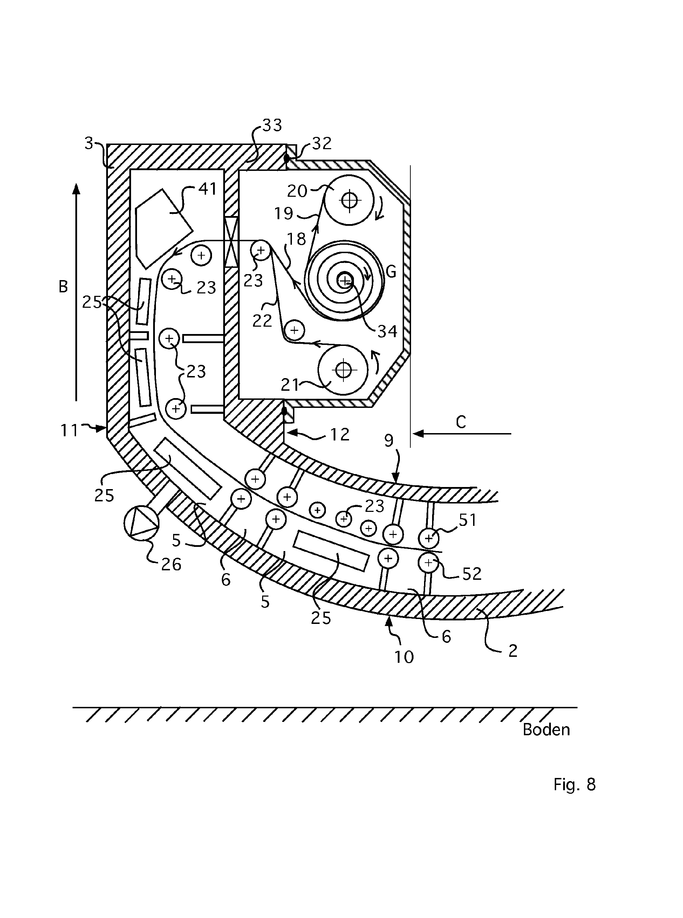

Die vierte Ausführungsform der erfindungsgemäßen Vorrichtung entspricht der zweiten Ausführungsform, außer dass der Abwickler 13 für das flexible Substrat 18 in entgegengesetzter Drehrichtung G rotiert wird (Fig. 8). Damit wird das flexible Substrat 18 beim Abwickeln zwischen dem Abwickler 14 und der nächsten Führungsrolle 23 in einer Gegenbiegung geführt, was jedoch aufgrund der erhöhten Biegebelastung nicht für alle flexiblen Substrate geeignet ist.

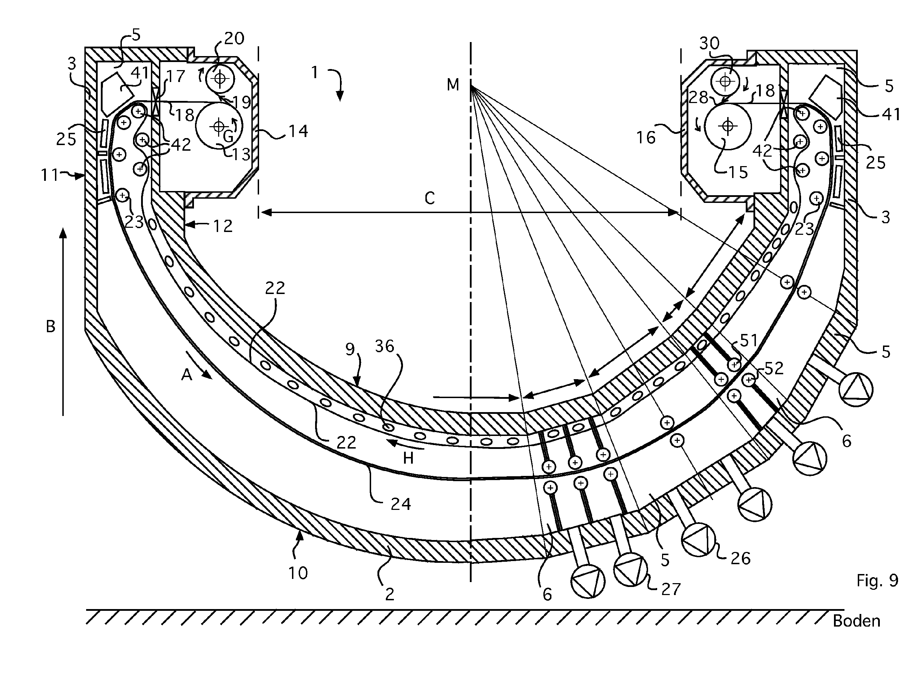

Die fünfte Ausführungsform der erfindungsgemäßen Vorrichtung entspricht der zweiten Ausführungsform, außer dass der bandförmige Träger 22 als Endlosband geführt wird (Fig. 9). Aus diesem Grund sind in den Wicklergehäusen 14, 16 kein Abwickler 21 und kein Aufwickler 29 für den bandförmigen Träger 22 vorgesehen. In den beiden Bearbeitungsmodulen 5, die die Schenkel 3 der Vorrichtung 1 bilden, sind jeweils Spannvorrichtungen für das Endlosband vorgesehen. Die Spannvorrichtungen weisen mehrere Rollen 42 auf. In den Spannvorrichtungen kann die Längendehnung des Endlosbandes eingestellt und ein Temperaturausgleich vorgenommen werden. Ferner sind in den Modulen 5, 6 Einrichtungen 36 zur Rückführung (Pfeil H) des bandförmigen Trägers 22 ausgebildet.

Die sechste Ausführungsform der erfindungsgemäßen Vorrichtung entspricht der zweiten Ausführungsform, außer dass das Trägermittel ein Segment-Trägermittel, das durch nur ein Modul 5 verläuft, ist. Aus diesem Grund sind in den Wicklergehäusen 14, 16 kein Abwickler 21 und kein Aufwickler 29 für den bandförmigen Träger 22 vorgesehen. Das Segment-Trägermittel weist einen in dem Modul 5 umlaufenden bandförmigen Träger 22 auf, der über zwei Rollen 37 geführt wird. Die Rollen sind ortsverstellbar (Pfeile L), um für die notwendige Spannung des bandförmigen Trägers 22 zu sorgen. Zwischen der Rückseite des bandförmigen Trägers 22 kann ein Hilfselement 38 angeordnet sein, das beispielsweise für eine Temperierung des bandförmigen Trägers 22 oder seine Unterstützung dienen kann.

Fig. 11 veranschaulicht die Funktionsweise eines Trennungsmoduls 6. Auch wenn das Trennungsmodul hier als Bestandteil einer Vorrichtung 1 beschrieben ist, so kann es dennoch unabhängig von der vorliegenden Erfindung als Vorrichtung zur Trennung zweier Räume eingesetzt werden.

Das Trennungsmodul 6 weist zwei gegenläufige, achsparallele Rollen 51, 52 auf. Die erste Rolle 51, die im Folgenden als Hauptrolle bezeichnet wird, ist an einem Abschnitt der Wandung, hier der Oberseite 9 des Moduls 6, die zweite Rolle 52, die im Folgenden als Gegenrolle bezeichnet wird, an einem gegenüberliegenden Abschnitt der Wandung, hier der Unterseite 10 des Moduls 6, befestigt. Zwischen den Mantelflächen der Hauptrolle 51 und der Gegenrolle 52 ist ein Spalt 53 ausgebildet. Beide Rollen 51, 52 sind angetrieben. Sie können dieselben Dimensionen haben. Zur Befestigung der Rollen 51, 52 kann jeweils ein Gestell 55 vorgesehen sein.

Um die Breite P des Spaltes 53 variieren zu können, ist die Gegenrolle 52 zweckmäßigerweise ortsverstellbar (Pfeil Q), während die Hauptrolle ortsfest ist. Für die Inbetriebnahme der Vorrichtung 1, d. h. zum Einlegen des flexiblen Substrates 18 oder des Kombinationssubstrates 24 in die Vorrichtung, kann es zweckmäßig sein, wenn die Gegenrolle 52, die im Betrieb der Vorrichtung 1 nicht an dem flexiblen Substrat 18 oder dem Kombinationssubstrat 24 anliegt, verstellt werden kann (Pfeil Q) und zwar so, dass sie das flexible Substrat 18 oder das Kombinationssubstrat 24 festklemmt. Auf diese Weise kann das flexible Substrat 18 oder das Kombinationssubstrat 24 schrittweise eingelegt und Stück für Stück festgeklemmt werden. Sind das flexible Substrat 18 oder das Kombinationssubstrat 24 dann jeweils vom Abwickler 13 (und, im Falle des Kombinationssubstrates 24, Abwickler 21) zum Aufwickler 15 (und, im Falle des Kombinationssubstrates 24, Aufwickler 29) verlegt, so kann die Gegenrollen 52 unter Bildung der Spalte 53 von den Hauptrollen 51 getrennt werden, so dass während des Betriebes der Vorrichtung 1 die Gegenrollen 52 das flexible Substrat 18 nicht berühren. Diese Vorgehensweise unterstützt die Inbetriebnahme der Vorrichtung 1 erheblich.

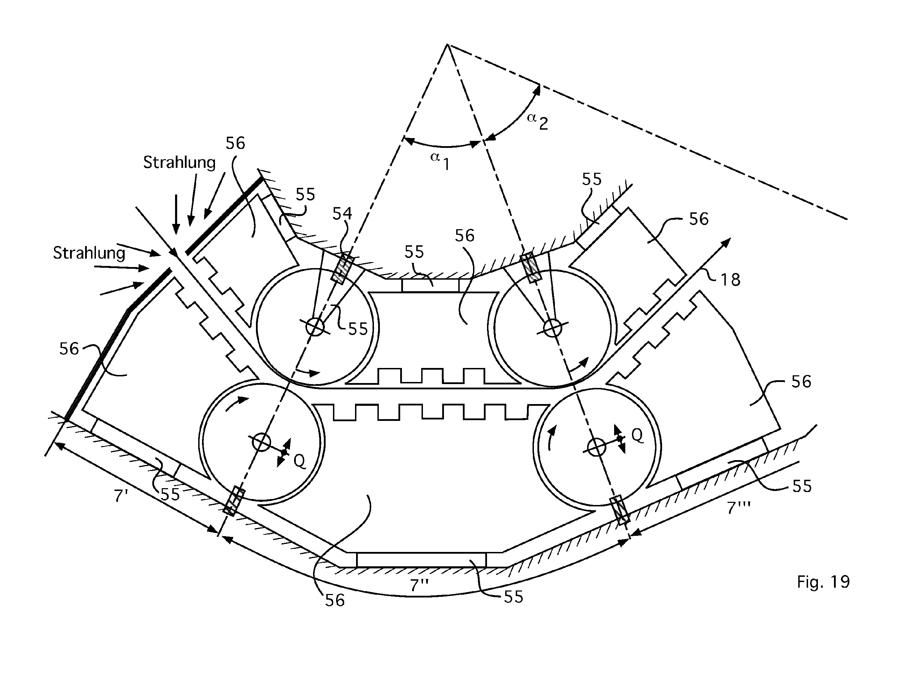

Die Hauptrolle 51 und die Gegenrolle 52 sind jeweils abgedichtet an dem jeweiligen Abschnitt der Wandungen 9, 10 befestigt, wozu Dichtungselemente 54 vorgesehen sind, die sich von den Wandungen 9, 10 aus erstrecken. Damit wird, abgesehen vom Spalt 53 der Innenraum 7 des Moduls 6 in zwei Teilbereiche 7', 7" geteilt, die nur über den Spalt 53 miteinander verbunden sind. Durch den Spalt 53 ist das Substrat 18 oder das Kombinationssubstrat 24 geführt. Dabei liegt das Substrat 18 mit seiner Rückseite, das Kombinationssubstrat 24 mit dem bandförmigen Träger 22 an der Hauptrolle 51 an. Die Vorderseite des flexiblen Substrates berührt die Gegenrolle 53 nicht. Zur Erhöhung des Wirkungsgrades der Gastrennung zwischen den Teilräumen 7', 7" können in einem oder beiden Teilräumen 7', 7" Spaltelemente 56 vorgesehen sein, die sich über die gesamte Länge der Gegenrolle 52 erstrecken. Die Spaltelemente 56 verhindern, dass die Gegenrolle 52 aufgrund ihrer Drehbewegung Gas von einem Teilraum in den anderen Teilraum transportiert. Außerdem blockieren sie in das Modul 6 eintretende Gasströme. Bei der Hauptrolle 51 übernimmt diese Funktionen das flexible Substrat 18 selbst. Alternativ oder zusätzlich können auch Spaltelemente 56 in einem oder beiden Teilräumen 7', 7" vorgesehen sein, die sich über die gesamte Länge der Hautrolle 51 erstrecken (Fig. 19).

In einer weiteren Ausführungsform des Trennungsmoduls 6 ist ein Spaltelement 56' vorgesehen, das das Spaltelement 56 ersetzt, das sich in Teilraum 7" befindet. Teilraum 7" ist der Teilraum, der sich, bezogen auf die Laufrichtung (Pfeil A) des flexiblen Substrates 18 stromabwärts des Rollenpaares 51, 52 befindet. Spaltelement 56' unterscheidet sich von Spaltelement 56 dadurch, dass es sich über die Gegenrolle 52 hinaus in Richtung der Hauptrolle 51 erstreckt und dass seine Oberseite 57, die dem flexiblen Substrat 18 zugewandt ist, dessen Lauf auf einer größeren Strecke folgt. Dabei kann der Abstand zwischen dem flexiblen Substrat 18 und der Oberseite 57 des Spaltelementes 56' der Spaltbreite P entsprechen. Damit wird ein besserer Wirkungsgrad erzielt. In Fig. 11 wird dies mit Bezug auf die Strecke X veranschaulicht. Der Abstand s₁ zwischen der Oberseite des Spaltelementes 56 und dem flexiblen Substrat 18 ist wesentlich größer als der Abstand s₂ zwischen der Oberseite 57 des Spaltelementes 56' und dem flexiblen Substrat 18. Gilt s₂ <<< s₁, so wird ein besonders hoher Wirkungsgrad erzielt.

Haupt- und Gegenrolle 51, 52 sollten mit der gleichen Geschwindigkeit angetrieben werden. Kommt es aufgrund unvorhersehbarer Umstände dennoch zu einer Berührung zwischen der Vorderseite des flexiblen Substrates 18 und der Gegenrolle 52, so werden auf diese Weise Beschädigungen des flexiblen Substrates auf einem minimalen Niveau gehalten.

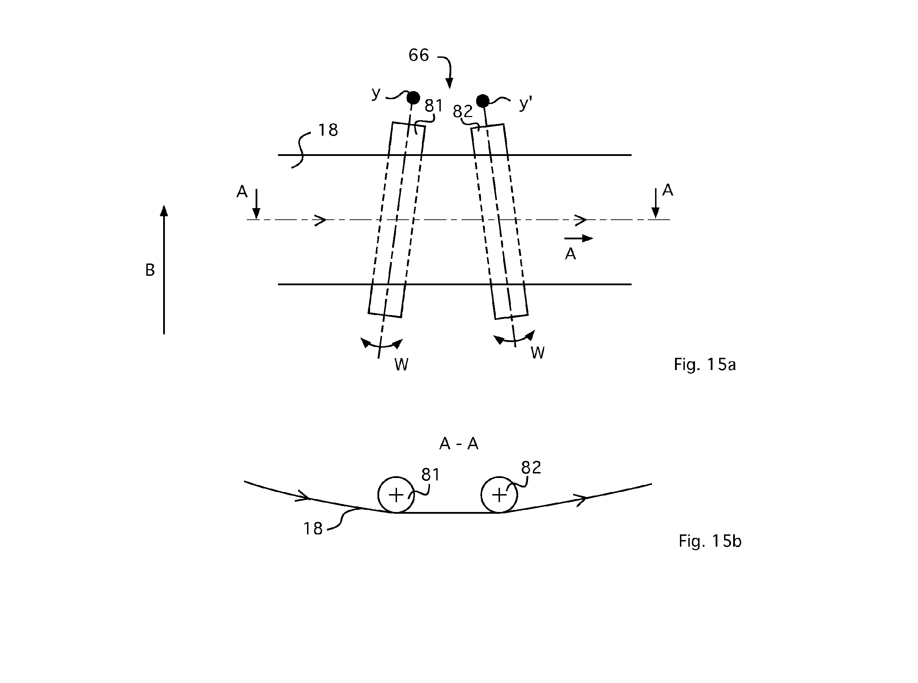

Die Hauptrolle und die Gegenrolle 51, 52 sind vorzugsweise achsparallele Rollen. Es kann jedoch vorgesehen sein, dass die Drehachsen der beiden Rollen 51, 52 verschränkt zueinander sind, d. h. die Drehachse einer der Rollen ist geneigt zur Drehachse der andere Rolle (siehe auch Figuren 15a und 15b, dort mit den Bezugszeichen 81, 82). Auf diese Weise kann sogar in einem Trennungsmodul eine Schwerkraftkompensation erreicht werden, was insbesondere bei einer vertikalen Führung des flexiblen Substrates 18 oder des Kombinationssubstrates 24 vorteilhaft ist.

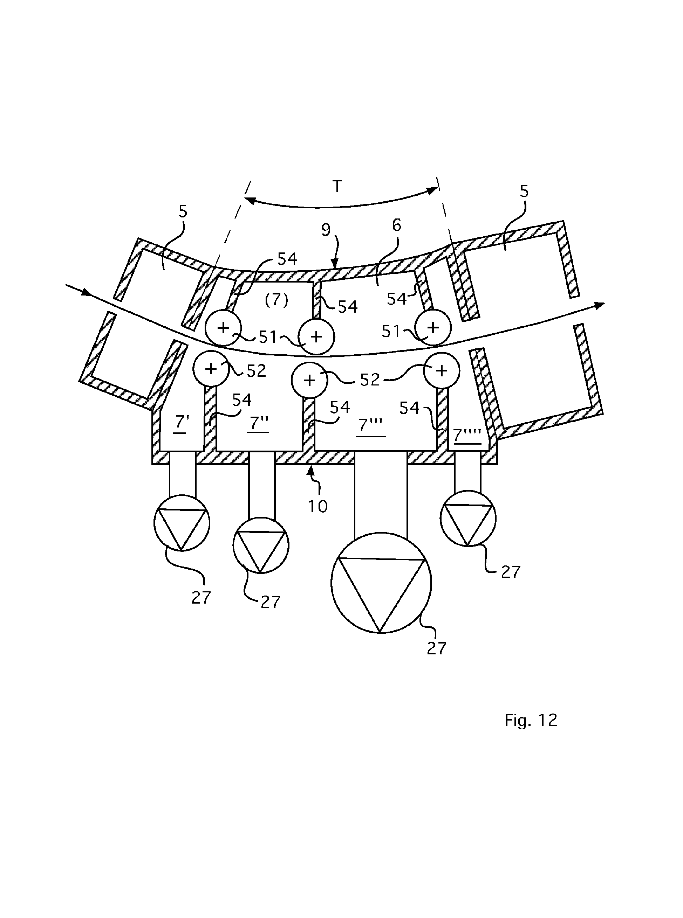

Fig. 12 zeigt eine zweite Ausführungsform eines Trennungsmoduls 6, das zwischen zwei Bearbeitungsmodulen 5, die nur angedeutet sind, angeordnet ist. In dem Trennungsmodul 6 sind mehrere Paare aus Haupt- und Gegenrolle 51, 52 angeordnet. In der gezeigten Ausführungsform sind drei solche Paare vorgesehen, so dass der Innenraum 7 des Moduls 6 in vier Teilräume 7', 7", 7"' und 7"" unterteilt ist. Jeder dieser Teilräume kann mit Einrichtungen zur Beeinflussung der physikalischen und/oder chemischen Bedingungen in diesem Teilraumen versehen sein. Im gezeigten Fall sind die Einrichtungen Pumpen. Je höher die Anzahl von Paaren an Haupt- und Gegenrolle ist, desto höher ist der Wirkungsgrad des Trennungsmoduls.

In Fig. 19 ist eine dritte Ausführungsform eines erfindungsgemäßen Trennungsmoduls gezeigt, das der in Fig. 12 gezeigten Ausführungsform entspricht, außer dass Spaltelemente 56 sowohl an den Gegenrollen 52 als auch an den Hauptrollen 51 angeordnet sind. Jede Rolle 51, 52 befindet sich damit zwischen zwei Spaltelementen 56. Damit werden die Rollen 51, 52 nahezu vollständig von den Spaltelementen 56 umschlossen, die lediglich zur gegenüberliegenden Rolle des Rollenpaares unter Ausbildung des Spaltes 53 freiliegen. Die Spaltelemente 56 sind dabei so angeordnet, dass zwischen den Spaltelementen 56, die an den Gegenrollen 52 angeordnet sind, und den Spaltelementen 56, die an der Hauptrollen 51 angeordnet sind, ein Spalt ausgebildet ist, durch den das flexible Substrat 18 oder das Kombinationssubstrat 24 geführt werden kann, ohne dass es die Oberseite 56 der Spaltelemente 56 berührt. Die Spaltelemente 56 sind mittels Gestellen 55 abgedichtet an der Wandung des Trennungsmoduls 6, hier der Oberseite 9 und der Unterseite 10, befestigt. Es ist in Fig. 19 zu erkennen, dass die Oberseite 57 der Spaltelemente 56, d. h. die dem flexiblen Substrat 16 oder dem Kombinationssubstrat 24 zugewandte Oberfläche der Spaltelemente 56, eine Strukturierung in Form von Nuten aufweisen kann. Die in Fig. 19 gezeigte Ausführungsform weist aufgrund der Anordnung der Spaltelemente und deren Gestaltung einen sehr guten Wirkungsgrad hinsichtlich der Gastrennung auf. Zusätzlich wird eine Strahlungsdichtigkeit erreicht, weil die Spaltelemente 56 einfallende Strahlung, insbesondere Strahlung, die an den Stirnseiten des Trennungsmoduls einfällt, blockieren können. Dazu können in die Spaltelemente 56 Strahlungsfallen eingebaut sein oder die Spaltelemente 56 als Strahlungsfallen gestaltet sein, in denen sich die Strahlung verfängt und umgelenkt wird. Ein Beispiel einer solchen Strahlungsfalle sind die in Fig. 19 gezeigten Nuten in der Oberseite 57 der Spaltelemente 56.

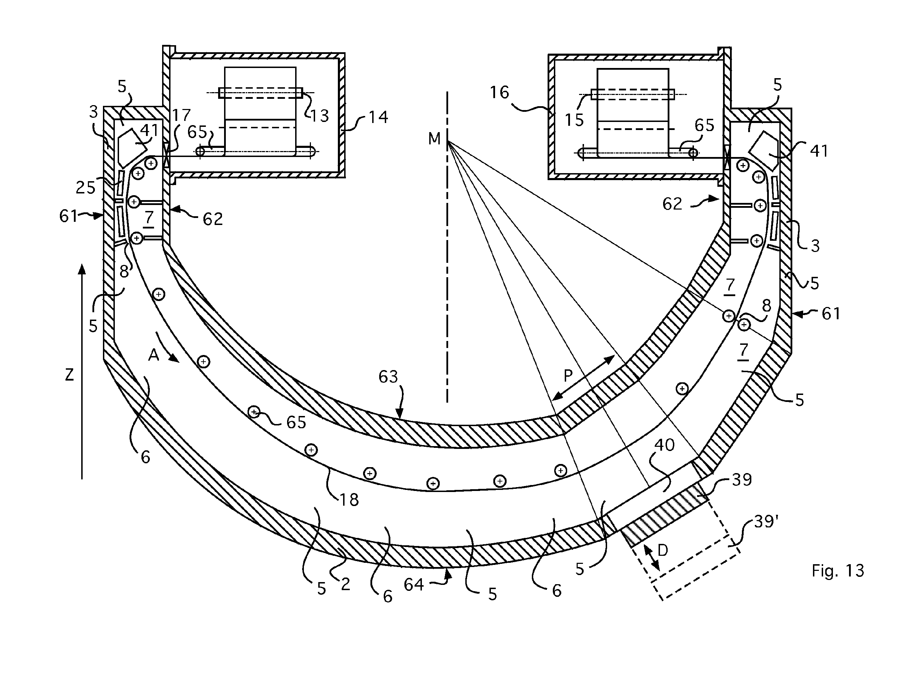

Die in Fig. 13 gezeigte siebte Ausführungsform einer erfindungsgemäßen Vorrichtung 1 weist einen C-förmigen Querschnitt auf. Dabei liegen die Basis 2 der Vorrichtung 1 und die Schenkel 3 der Vorrichtung 1 in einer Ebene (der Papierebene), die parallel zur Bodenebene verläuft. Die Schenkel 3 erstrecken sich senkrecht von der Basis 2 im Wesentlichen parallel zur Bezugsrichtung (Pfeil Z), die parallel zur Bodenebene verläuft. Die Basis 2 und die Schenkel 3 sind aus mehreren Modulen 5, 6 zusammengesetzt. Die Module 5 sind Bearbeitungsmodule, die Module 6 Trennungsmodule.

Die Module 5, 6 weisen jeweils einen von einer Wandung umgebenen Innenraum 7 auf. Die Module 5, 6 grenzen an ihren Stirnseiten aneinander. In den Stirnseiten der Module 5, 6 sind Durchführungen 8 für das flexible Substrat 18 ausgebildet. Die Abschnitte der Wandung der Module 5, 6, an die kein anderes Modul angrenzt, bilden die Außenwände 61, 62, 63, 64 der Vorrichtung 1, die alle senkrecht zur Bodeneben verlaufen. Die Module 5, 6 der Basis 2 bilden dabei die innere Längsseite 63, die zwischen den Schenkeln 3 liegt, und die äußere Längsseite 64, die der inneren Längsseite 63 gegenüberliegt, der Vorrichtung 1 aus. Die Module 5, die sich an den Enden der Basis 2 befinden, und die Module 5, die die Schenkel 3 bilden, bilden dabei die äußeren Querseiten 61 und die inneren Querseiten 62 der Vorrichtung 1.

Die innere und die äußere Längsseite 63, 64 der Basis 2 sind gekrümmt. Die Module 5, 6 der Basis 2 sind dabei auf einem Kreisbogen angeordnet, dessen Mittelpunkt M außerhalb der Basis 2 mittig zwischen dem Wicklergehäuse 14 und dem Wicklergehäuse 16 liegt. Zur Vereinfachung der Darstellung sind nicht alle Einzelheiten, die in Fig. 1 gezeigt werden, auch in Fig. 13 dargestellt. Insbesondere wurde auf die Darstellung aller Stirnseiten der Module 5, 6, die diese voneinander abgrenzen, verzichtet.

An den inneren Querseiten 62 der Vorrichtung 1, d. h. den Innenseiten der Schenkel 3, sind der Abwickler 13 in einem Wicklergehäuse 14 und der Aufwickler 15 in einem Wicklergehäuse 16 angeordnet. Dabei grenzen die Wicklergehäuse 14, 16 jeweils an ein Modul 5 der Vorrichtung 1 an. Die Durchführung 8 zwischen diesen Modulen 5 und den Wicklergehäusen 14, 16 ist als Ventil 17 ausgestaltet.

Von dem Abwickler 13 wird das flexible Substrat 18 abgewickelt. Die Längsachse des Coils des Abwicklers 13 verläuft horizontal zur Papierebene. Es sind daher im Wicklergehäuse 14 Umlenkrollen 65 vorgesehen, mit denen das horizontal abgewickelte flexible Substrat 18 in eine Lage gebracht wird, die eine vertikale Führung durch die Module 5, 6 ermöglicht. In der in Fig. 13 gezeigten Ausführungsform sind keine Zwischenlagen und keine Trägermittel vorgesehen. Es ist jedoch möglich, auch eine Zwischenlage und/oder ein Trägermittel zu verwenden.

Das flexible Substrat 18 wird in vertikaler Führung durch die Module 5, 6 der Vorrichtung 1 transportiert. In den Modulen 5, 6 sind Führungsmittel 66 zur Schwerkraftkompensation, die im Folgenden als Kompensationsmittel bezeichnet werden, vorgesehen, die das flexible Substrat 18 halten. Mittels dieser Kompensationsmittel 66 wird das flexible Substrat 18 vom Abwickler 13 zum Aufwickler 15 transportiert. Es ist zu erkennen, dass die Kompensationsmittel 66 das flexible Substrat 18 nicht an seiner Vorderseite kontaktieren. Sie stehen nur in Kontakt mit der Rückseite des flexiblen Substrates 18.

Ausgehend vom Abwickler 13 durchläuft das flexible Substrat 18 die Module 5, 6 in der in Fig. 1 beschriebenen Reihenfolge (Pfeil A). Die Module 5, 6 haben - abgesehen von der vertikalen Führung des flexiblen Substrates 18 und dem damit verbundenen Einsatz von Kompensationsmitteln 66 anstelle der Führungsrollen 23 - den gleichen Aufbau und die gleichen Funktionen. Nach dem Passieren des letzten Moduls 5, das den zweiten Schenkel 3 bildet, gelangt das flexible Substrat 18 in den Aufwickler, läuft über eine Umlenkrolle 65 und wird am Aufwickler 15, dessen Coil ebenfalls eine horizontal zur Bodenebene verlaufende Drehachse aufweise, aufgewickelt.

In Fig. 13 ist die gute Zugänglichkeit zu den Modulen der Prozesssektionen zu erkennen. Diese gute Zugänglichkeit kann bei einem vertikalen Bahnlauf sehr einfach mit bekannten Lösungen, beispielsweise mit Wagen auf Schienen, welche manuell oder motorisch geöffnet werden können, realisiert werden. Vorteile des vertikalen Bahnlaufs sind insbesondere in der Prozesstechnik begründet. Beispielsweise können Partikel von oben nach unten fallen, ohne dabei auf dem Substrat zu landen. Weiterhin ist in Fig. 13 gezeigt, dass die vertikal laufende Substratbahn in den Wickelbereichen in die horizontal angeordneten Wickler 13, 15 umgelenkt werden kann, und zwar über die zweckmäßig angeordnete Walze 65. Diese Anordnung der Walze 65 erleichtert das Handling und die Ab- oder Aufwickelvorgänge am Coil, die vor allem in horizontaler Lage beherrschbar sind.

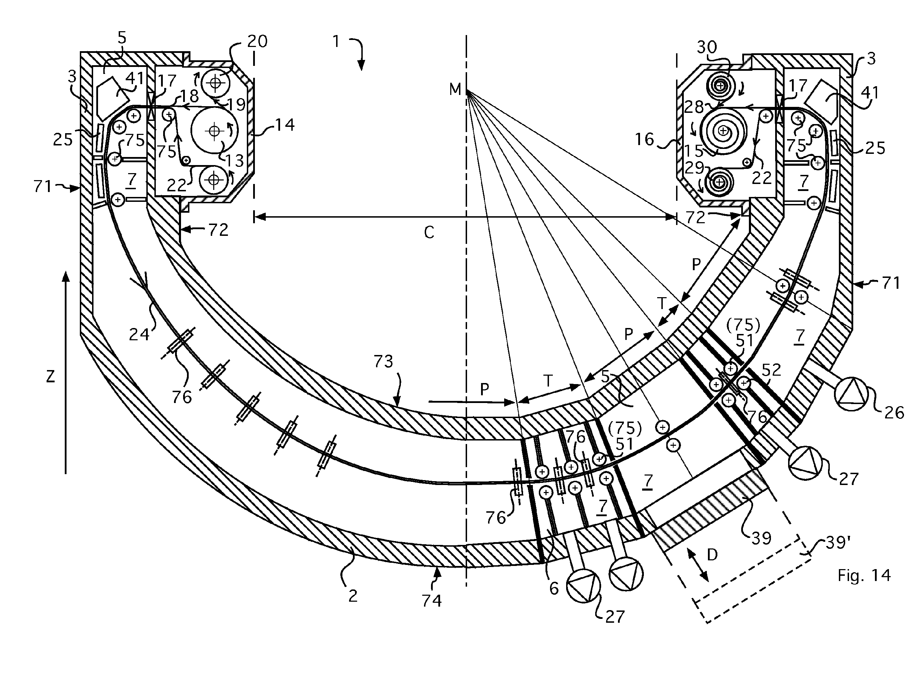

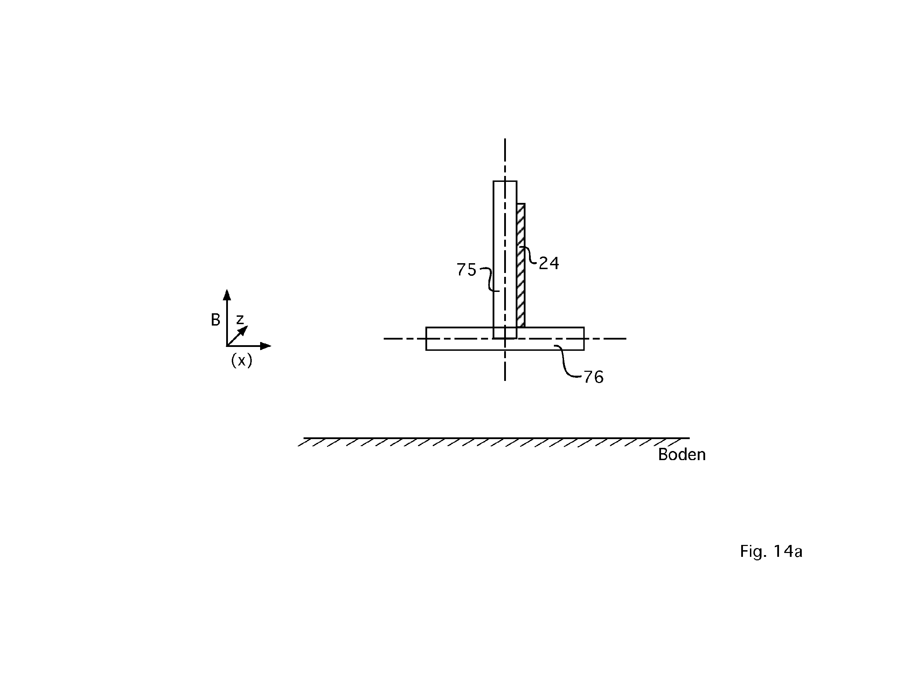

Die in Fig. 14 gezeigte achte Ausführungsform einer erfindungsgemäßen Vorrichtung 1 weist einen C-förmigen Querschnitt auf. Dabei liegen die Basis 2 der Vorrichtung 1 und die Schenkel 3 der Vorrichtung 1 in einer Ebene (der Papierebene), die parallel zur Bodenebene verläuft. Die Schenkel 3 erstrecken sich senkrecht von der Basis 2 im Wesentlichen parallel zur Bezugsrichtung (Pfeil Z), die parallel zur Bodenebene verläuft. Die Basis 2 und die Schenkel 3 sind aus mehreren Modulen 5, 6 zusammengesetzt. Die Module 5 sind Bearbeitungsmodule, die Module 6 Trennungsmodule.

Die Module 5, 6 weisen jeweils einen von einer Wandung umgebenen Innenraum 7 auf. Die Module 5, 6 grenzen an ihren Stirnseiten aneinander. In den Stirnseiten der Module 5, 6 sind Durchführungen 8 für das flexible Substrat 18 ausgebildet. Die Abschnitte der Wandung der Module 5, 6, an die kein anderes Modul angrenzt, bilden die Außenwände 71, 72, 73, 74 der Vorrichtung 1, die alle senkrecht zur Bodeneben verlaufen. Die Module 5, 6 der Basis 2 bilden dabei die innere Längsseite 73, die zwischen den Schenkeln 3 liegt, und die äußere Längsseite 74, die der inneren Längsseite 73 gegenüberliegt, der Vorrichtung 1 aus. Die Module 5, die sich an den Enden der Basis 2 befinden, und die Module 5, die die Schenkel 3 bilden, bilden dabei die die Querseiten 71 und die inneren Querseiten 72 der Vorrichtung 1.

Die innere und die äußere Längsseite 73, 74 der Basis 2 sind gekrümmt. Die Module 5, 6 der Basis 2 sind dabei auf einem Kreisbogen angeordnet, dessen Mittelpunkt M außerhalb der Basis 2 mittig zwischen dem Wicklergehäuse 14 und dem Wicklergehäuse 16 liegt. Zur Vereinfachung der Darstellung sind nicht alle Einzelheiten, die in Fig. 1 gezeigt werden, auch in Fig. 13 dargestellt. Insbesondere wurde auf die Darstellung aller Stirnseiten der Module 5, 6, die diese voneinander abgrenzen, verzichtet.

An den inneren Seitenwänden 12 der Vorrichtung 1, d. h. den Innenseiten der Schenkel 3, sind der Abwickler 13 in einem Wicklergehäuse 14 und der Aufwickler 15 in einem Wicklergehäuse 16 angeordnet. Dabei grenzen die Wicklergehäuse 14, 16 jeweils an ein Modul 5 der Vorrichtung 1 an. Die Durchführung 8 zwischen diesen Modulen 5 und den Wicklergehäusen 14, 16 ist als Ventil 17 ausgestaltet.

Von dem Abwickler 13 wird das flexible Substrat 18 abgewickelt. Dabei wird die Zwischenlage 19, die die Wicklungen des flexiblen Substrates 18 auf dem Coil trennt, von dem Coil abgewickelt und auf einem gesonderten Aufwickler 20 für die Zwischenlage 19 aufgewickelt, der ebenfalls im Wicklergehäuse 14 angeordnet ist. Außerdem ist in dem Wicklergehäuse 14 ein Abwickler 21 für ein Trägermittel mit einem bandförmigen Träger 22 angeordnet. Der bandförmige Träger 22 ist ein endliches Trägersubstrat. Es wird im Wicklergehäuse 14 mit dem flexiblen Substrat 18 zusammengeführt, wodurch ein Kombinationssubtrat 24 gebildet wird. Das Kombinationssubstrat 24 besteht aus dem flexiblen Substrat 18 und dem bandförmigen Träger 22, der mit einer seiner Flächenseiten an der Rückseite des flexiblen Substrates 18 anliegt. Mittels des bandförmigen Trägers 22 wird das flexible Substrat 18 in horizontaler Führung durch die Module 5, 6 der Vorrichtung 1 transportiert. In den Wicklergehäusen 14, 16 und einigen Modulen 5, 6 sind weitere Führungsmittel, insbesondere vertikale Führungsrollen 75 und horizontale Stützrollen 76 vorgesehen, um das Kombinationssubstrat 24 vom Abwickler 13 zum Aufwickler 15 zu transportieren. Es ist zu erkennen, dass die Führungsmittel das flexible Substrat 18 nicht an seiner Vorderseite kontaktieren. Sie stehen nur in Kontakt mit dem Träger 22 des Kombinationssubstrates 24.

Das Kombinationssubstrat 24 steht mit seiner Unterkante auf den horizontalen Stützrollen 76 auf, während es durch die Module 5, 6 der Vorrichtung 1 transportiert wird. Die vertikalen Führungsrollen 75 halten das Kombinationssubstrat 24 dabei in der Lage, die eine vertikale Führung zulässt (siehe Fig. 14a, in der Pfeil B vertikal zur Bodenebene verläuft).

Ausgehend vom Abwickler 13 durchläuft das flexible Substrat 18 die Module 5, 6 in der in Fig. 1 beschriebenen Reihenfolge (Pfeil A). Die Module 5, 6 haben - abgesehen von der vertikalen Führung des flexiblen Substrates 18 und dem damit verbundenen Einsatz von horizontalen Stützrollen 76 und vertikalen Führungsrollen 75 anstelle der Führungsrollen 23 - den gleichen Aufbau und die gleichen Funktionen. Nach dem Passieren des letzten Moduls 5, das den zweiten Schenkel 3 der Vorrichtung 1 bildet, gelangt das Kombinationssubstrat 24, ebenso wie in der ersten Ausführungsform, zu dem im Wicklergehäuse 16 angeordneten Aufwickler 20, auf dem das flexible Substrat 18 nach Trennung von dem bandförmigen Träger 22 unter Einschiebung einer Zwischenlage 28 aufgewickelt wird. Der bandförmige Träger 22 wird auf einem gesonderten Aufwickler 29, der in dem Wicklergehäuse 16 angeordnet ist, aufgewickelt. Die Zwischenlage 28 wird von einem Abwickler 30, der sich ebenfalls in dem Wicklergehäuse 16 befindet, abgewickelt.

Die Abschnitte in der Basis 2, in denen eine Bearbeitung des flexiblen Substrates 18 erfolgen kann, sind mit dem Buchstaben P, die Abschnitte in der Basis 2, die der Trennung der Bearbeitungsmodul 5 dienen, sind mit dem Buchstaben T gekennzeichnet. Es ist zu erkennen, dass jeweils ein Trennungsabschnitt T, der von einem Trennungsmodul 6 gebildet wird, zwischen zwei Prozessabschnitten P angeordnet ist. In Fig. 14 sind einige die Trennungsmodule 6 jeweils mit einer oder mehreren Pumpen 27 gezeigt, um zu verdeutlichen, dass sich die Bedingungen in dem Innenraum 7 der Trennungsmodule 6 von denen in der Umgebung unterscheiden können. In den Bearbeitungsmodulen 5, aber auch in den Trennungsmodulen 6 können Messinstrumente 41 angeordnet sein.

Zur Vereinfachung der Darstellung sind nicht alle Einzelheiten, die in Fig. 1 gezeigt werden, auch in den Figuren 13 und 14 dargestellt. Insbesondere wurde auf die Darstellung von Einzelheiten der Module 5, 6 verzichtet.

Aufgrund der vertikalen Führung ist die Bearbeitungsrichtung seitlich, d. h. die Prozessstationen 25 wirken von der Seite auf das flexible Substrat 25 ein, was die Verschmutzung des flexiblen Substrates 18 minimiert. Das ist bei vielen Bearbeitungsprozessen vorteilhaft.

Die Figuren 15 bis 18 zeigen Kompensationsmittel 66, die zur vertikalen Führung des flexiblen Substrates 18 oder des Kombinationssubstrats 24 (nicht gezeigt) eingesetzt werden können. Die Figuren 15a und 15b zeigen ein Paar verschränkter Rollen 81, 82, deren Drehachsen nicht parallel zueinander sind und die um einen Punkt Y, Y' geschwenkt werden können (Pfeile W und W'). An den Mänteln der Rollen 81, 82 liegt das flexible Substrat 18 mit seiner Rückseite an. Das flexible Substrat 18 steht in den Figuren 15a und 15b vertikal zur Bodenfläche (Pfeil B).

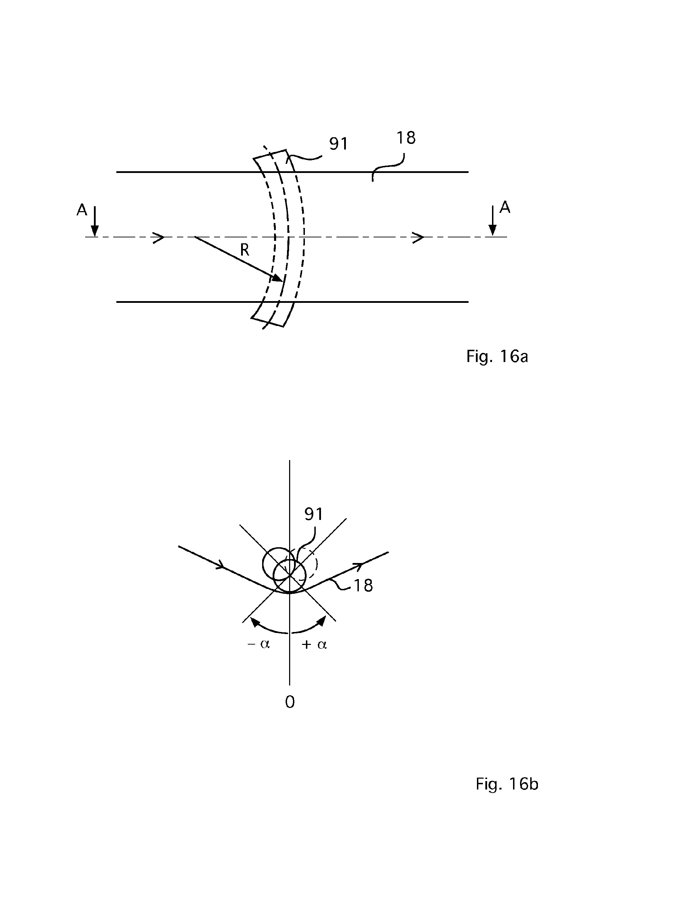

Bei der in den Figuren 16a und 16b gezeigten Ausführungsform handelt es sich um eine Bogenrolle 91, über die das flexible Substrat 18 geführt ist. Es ist in Fig. 16b zu erkennen, dass sich die Lage des Mantels bei der Schwenkung der Bogenrolle verändert. Ausgehend von einer Lage mit Wert Null wird dabei eine Position zwischen -a oder +a eingenommen.

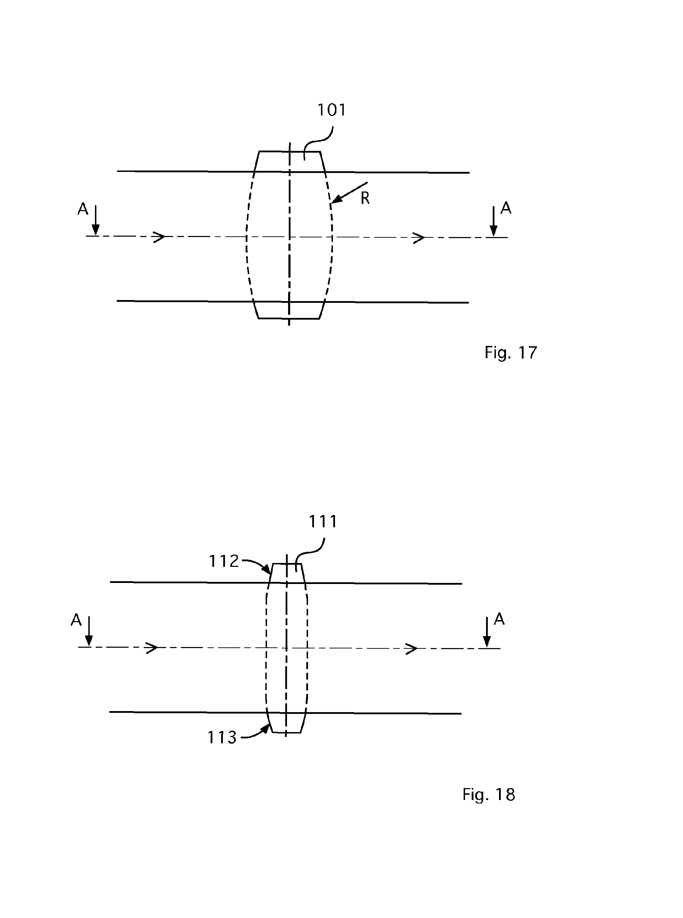

Bei der in Fig. 17 gezeigten Ausführungsform weist die Rolle 101 eine Oberflächenmodifikation auf. Dabei ist die Mantelfläche ballig mit einem Radius R ausgebildet.

Bei der in Fig. 18 gezeigten Ausfiihrungsform weist die Rolle 111 eine Oberflächenmodifikation in Form einer Fase 112 und einer Abrundung 113 auf. Die Fase 112 ist dabei in einem Bereich der Mantelfläche der Rolle 111 ausgebildet, die an eine ihrer Stirnseiten angrenzt. Die Abrundung 113 ist dabei in einem Bereich der Mantelfläche der Rolle 111 ausgebildet, die an die andere Stirnseite angrenzt. Es können aber auch in beiden Bereichen Fasen oder in beiden Bereichen Abrundungen vorgesehen sein.

### Bezugszeichenliste

- 1: Vorrichtung
- 2: Basis
- 3: Schenkel

- 5: Bearbeitungsmodul
- 6: Trennungsmodul
- 7: Innenraum
- 8: Durchführung
- 9: Oberseite
- 10: Unterseite
- 11: äußere Seitenwand
- 12: innere Seitenwand
- 13: Abwickler
- 14: Wicklergehäuse
- 15: Aufwickler
- 16: Wicklergehäuse
- 17: Ventil
- 18: flexibles Substrat
- 19: Zwischenlage
- 20: Aufwickler
- 21: Abwickler
- 22: bandförmiger Träger
- 23: Führungsrolle
- 24: Kombinationssubstrat
- 25: Prozessstation
- 26: Pumpe
- 27: Pumpe
- 28: Zwischenlage
- 29: Aufwickler
- 30: Abwickler
- 31: Tür
- 32: Dichtung
- 33: starre Wandung
- 34: Trägerrolle
- 35: Lager
- 36: Rückführungseinrichtungen
- 37: Rolle
- 38: Hilfselement
- 39: Prozessflansch
- 40: Öffnung
- 41: Messinstrument
- 42: Rolle
- 43: Gestell

- 51: Hauptrolle
- 52: Gegenrolle
- 53: Spalt
- 54: Abdichtung
- 55: Gestell
- 56: Spaltelement
- 57: Oberseite

- 61: äußere Querseite
- 62: innere Querseite
- 63: innere Längsseite
- 64: äußere Längsseite
- 65: Umlenkrolle
- 66: Kompensationsmittel

- 71: äußere Querseite
- 72: innere Querseite
- 73: innere Längsseite
- 74: äußere Längsseite
- 75: vertikale Führungsrolle
- 76: horizontale Stützrolle

- 81: Rolle
- 82: Rolle

- 91: Bogenrolle

- 101: ballige Rolle

- 111: Rolle
- 112: Fase
- 113: Abrundung

## Patentansprüche

1. Vorrichtung zum Bearbeiten flexibler, bandförmiger Substrate (18), wobei die Vorrichtung (1) einen Abwickler (13) und einen Aufwickler (15) für das flexible Substrat (18), Einrichtungen (25) zur Bearbeitung des flexiblen Substrates (18) sowie Mittel (23, 66, 75, 76, 81, 82, 91, 101, 111) zur Führung des flexiblen Substrates (18) vom Abwickler (13) zum Aufwickler (15) aufweist, **dadurch gekennzeichnet, dass** die Vorrichtung (1) einen modularen Aufbau mit mehreren aneinander angrenzenden Modulen (5, 6), durch die das flexible Substrat (18) geführt ist, besitzt, wobei die Module (5, 6) in einer Anordnung, die eine Basis (2) und daran anschließende, einander zugewandte Schenkel (3) aufweist, angeordnet sind.

2. Vorrichtung nach Anspruch 1, **dadurch gekennzeichnet, dass** der Abwickler (13) und der Aufwickler (15) an den Innenseiten (12, 62) der Schenkel (3) der Anordnung angeordnet sind.

3. Vorrichtung nach Anspruch 1 oder Anspruch 2, **dadurch gekennzeichnet, dass** ein Modul (5, 6) einen von einer Wandung umschlossenen Innenraum (7) aufweist, wobei in der Wandung Durchführungen (8) für das flexible Substrat (18) ausgebildet sind.

4. Vorrichtung nach einem der vorstehenden Ansprüche, **dadurch gekennzeichnet, dass** sie zumindest ein erstes Modul (5) als Bearbeitungsmodul umfasst, wobei in dem Bearbeitungsmodul zumindest eine Einrichtung (25) zum Bearbeiten des flexiblen Substrates (18) angeordnet ist.

5. Vorrichtung nach einem der vorstehenden Ansprüche, **dadurch gekennzeichnet, dass** die Mittel (23, 66, 75, 76, 81, 82, 91, 101, 111) zur Führung des flexiblen Substrates (18) vom Abwickler (13) zum Aufwickler (15) so angeordnet sind, dass sie nur eine Flächenseite des flexiblen Substrates (18) während seines Laufs vom Abwickler (13) zum Aufwickler (15) kontaktieren.

6. Vorrichtung nach einem der vorstehenden Ansprüche, **dadurch gekennzeichnet, dass** die Mittel (23, 66, 75, 76, 81, 82, 91, 101, 111) (23, 66, 75, 76, 81, 91, 101, 111) zum Führen des flexiblen Substrates (18) ein Trägermittel mit einem bandförmigen Träger (22) umfassen, der mit einer Flächenseite an dem flexiblen Substrat (18) anliegt.

7. Vorrichtung nach Anspruch 6, **dadurch gekennzeichnet, dass** ein Trägerband-Abwickler (21) und ein Trägerband-Aufwickler (20) für den bandförmigen Träger (29) vorgesehen sind oder dass der bandförmige Träger (22) als Endlosband um voneinander beabstandete Rollen (37, 42) geführt ist.

8. Vorrichtung nach einem der vorstehenden Ansprüche, **dadurch gekennzeichnet, dass** sie zumindest ein zweites Modul (6) als Trennungsmodul umfasst, das zwischen Modulen (5) angeordnet ist, in deren Innenräumen (7) unterschiedliche physikalische und/oder chemische Bedingungen herrschen, wobei im Innenraum (7) des zweiten Moduls zwei einander unter Ausbildung eines Spaltes (53) gegenüberliegende und gegen die Wandung des Moduls (6) abgedichtete Rollen (51, 52) angeordnet sind und das flexible Substrat (6) durch den Spalt (53) geführt ist, wobei es mit einer seiner Flächenseiten an einer Rolle (51) anliegt, während die andere Flächenseite freiliegt.

9. Vorrichtung nach Anspruch 8, **dadurch gekennzeichnet, dass** beide Rollen (51, 52) gegenläufig angetriebene Rollen sind.

10. Vorrichtung nach Anspruch 8 oder Anspruch 9, **dadurch gekennzeichnet, dass** der Spalt (53) eine Spaltbreite (P) besitzt, die nicht größer als das Zehnfache der Stärke des flexiblen Substrates (18) ist.

11. Vorrichtung nach einem der Ansprüche 8 bis 10, **dadurch gekennzeichnet, dass** sie mehrere aufeinanderfolgende Paare von Rollen (51, 52) umfasst, die einander jeweils unter Ausbildung eines Spaltes (53) gegenüberliegen und gegen die Wandung des Moduls (6) abgedichtet sind, wobei das flexible Substrat (18) durch die Spalte (53) der Paare von Rollen (51, 52) geführt ist, wobei es mit einer seiner Flächenseiten an jeweils einer der Rollen (51) des Paares von Rollen (51, 52) anliegt, während die andere Flächenseite freiliegt.

12. Vorrichtung nach einem der vorstehenden Ansprüche, **dadurch gekennzeichnet, dass** das flexible Substrat (18) in horizontaler Führung durch die Vorrichtung (1) geführt ist, wobei es mit seinen Flächenseiten parallel zur Bodenebene mit einer Winkelabweichung von maximal +/-45° geführt ist.

13. Vorrichtung nach einem der Ansprüche 1 bis 11, **dadurch gekennzeichnet, dass** das flexible Substrat (18) in vertikaler Führung durch die Vorrichtung (1) geführt ist, wobei es mit seinen Flächenseiten aufrecht zur Bodenebene mit einer Winkelabweichung von maximal +/-89° geführt ist.

14. Vorrichtung nach Anspruch 13, **dadurch gekennzeichnet, dass** sie zur vertikalen Führung des flexiblen Substrates (18) Mittel (23, 66, 75, 76, 81, 82, 91, 101, 111) zum Führen des flexiblen Substrates (18) umfasst, die aus der Gruppe ausgewählt sind, die aus einem Paar benachbarter Rollen (81, 82) mit nichtparallelen Drehachsen, einer Bogenrolle (91) und einer Rolle (101, 111) mit gewölbter Mantelfläche sowie Kombinationen davon besteht.

15. Vorrichtung zur Trennung von zwei Räumen, in denen unterschiedliche physikalische und/oder chemische Bedingungen herrschen, wobei die Vorrichtung (6) eine Kammer mit einer Durchführung zum Einbringen eines flächigen Substrates (18) in die Kammer und einer Durchführung zum Ausbringen des Substrates (18) aus der Kammer aufweist und wobei in der Kammer zwei einander unter Ausbildung eines Spaltes (53) gegenüberliegende und gegen die Wandung der Kammer abgedichtete Rollen (51, 52) angeordnet sind und das Substrat (18) durch den Spalt (53) geführt ist, wobei es mit einer seiner Flächenseiten an einer Rolle (51) anliegt, während die andere Flächenseite (52) freiliegt.
